# EUROPEAN PATENT APPLICATION

(11) **EP 4 435 848 A1**
(43) Date of publication of application: **25.09.2024**
(21) Application number: 24159946.3
(22) Date of filing: 27.02.2024
(51) Int. Cl.: H01L 21/8234, H01L 27/088, H01L 29/417, H01L 29/775

(54) **INTEGRATED CIRCUIT DEVICE**

(30) Priority: 21.03.2023 KR 20230036923
(71) Applicant: Samsung Electronics Co., Ltd., Suwon-si, Gyeonggi-do 16677 (KR)
(72) Inventor: LEE, Doohyun, 16677 Suwon-si, Gyeonggi-do (KR); SHIN, Heonjong, 16677 Suwon-si, Gyeonggi-do (KR); PARK, Juneyoung, 16677 Suwon-si, Gyeonggi-do (KR); JANG, Jaeran, 16677 Suwon-si, Gyeonggi-do (KR)
(74) Representative: Kuhnen & Wacker Patent- und Rechtsanwaltsbüro PartG mbB

(57) **Abstract**

An integrated circuit device, including a substrate having a plurality of device regions extending in a first horizontal direction, a plurality of gate electrodes on the plurality of device regions extending in a second horizontal direction that is orthogonal to the first horizontal direction, a plurality of source/drain regions each between a pair of gate electrodes adjacent to each other in the first horizontal direction among the plurality of gate electrodes, the plurality of source/drain regions being on portions of the plurality of device regions, a plurality of gate cut regions cutting the plurality of gate electrodes and extending in the first horizontal direction, and a plurality of contact structures including a plurality of contact body portions and a plurality of contact finger portions, the plurality of contact body portions filling the plurality of gate cut regions and extending in the first horizontal direction.

## Description

### BACKGROUND

### 1. Field

An integrated circuit device including a lower wiring structure is disclosed.

### 2. Description of the Related Art

With the development of electronics technology, down-scaling of integrated circuit devices has been in rapid progress. To efficiently transmit power to integrated circuit devices having a high integration density, integrated circuit devices having a power delivery network are being introduced.

### SUMMARY

Embodiments are directed to an integrated circuit device, including a substrate including a plurality of device regions extending in a first horizontal direction, a plurality of gate electrodes on the plurality of device regions extending in a second horizontal direction that is orthogonal to the first horizontal direction, a plurality of source/drain regions each located between a pair of gate electrodes adjacent to each other in the first horizontal direction among the plurality of gate electrodes, the plurality of source/drain regions being on portions of the plurality of device regions, a plurality of gate cut regions cutting the plurality of gate electrodes and extending in the first horizontal direction, and a plurality of contact structures including a plurality of contact body portions and a plurality of contact finger portions, the plurality of contact body portions filling the plurality of gate cut regions and extending in the first horizontal direction, and the plurality of contact finger portions extending in the second horizontal direction from the plurality of contact body portions and being connected to at least some of the plurality of source/drain regions.

Embodiments are directed to an integrated circuit device, including a substrate including a plurality of device regions extending in a first horizontal direction, a plurality of gate structures including a plurality of gate electrodes and a plurality of gate spacers, the plurality of gate electrodes being on the plurality of device regions and extending in a second horizontal direction that is orthogonal to the first horizontal direction, and the plurality of gate spacers covering side surfaces of the plurality of gate electrodes, a plurality of source/drain regions each located between a pair of gate structures adjacent to each other in the first horizontal direction among the plurality of gate structures, the plurality of source/drain regions being on portions of the plurality of device regions, a plurality of first gate cut regions cutting the plurality of gate electrodes and extending in the first horizontal direction, and a plurality of contact structures separated from the plurality of gate electrodes by the plurality of gate spacers, the plurality of contact structures including a plurality of contact body portions and a plurality of contact finger portions, the plurality of contact body portions filling the plurality of first gate cut regions and extending in the first horizontal direction, and the plurality of contact finger portions extending in the second horizontal direction from the plurality of contact body portions and being connected to at least some of the plurality of source/drain regions.

Embodiments are directed to an integrated circuit device, including a substrate including a plurality of device regions extending in a first horizontal direction, a plurality of gate structures including a plurality of gate electrodes, a gate capping layer on the plurality of gate electrodes, a plurality of gate spacers, and a plurality of gate insulating films, the plurality of gate electrodes being on the plurality of device regions and extending in a second horizontal direction that is orthogonal to the first horizontal direction, the plurality of gate spacers covering side surfaces of the plurality of gate electrodes and surrounding the side surfaces of the plurality of gate electrodes according to a top view, and the plurality of gate insulating films being between the plurality of gate electrodes and the plurality of gate spacers, a plurality of source/drain regions each located between a pair of gate structures adjacent to each other in the first horizontal direction among the plurality of gate structures, the plurality of source/drain regions being on portions of the plurality of device regions, a plurality of first gate cut regions cutting the plurality of gate electrodes and each extending in the first horizontal direction between a pair of device regions adjacent to each other in the second horizontal direction among the plurality of device regions, and a plurality of contact structures separated from the plurality of gate electrodes by the plurality of gate spacers, the plurality of contact structures including a plurality of contact body portions and a plurality of contact finger portions, the plurality of contact body portions filling the plurality of first gate cut regions, extending in the first horizontal direction, and extending into the substrate in a vertical direction, and the plurality of contact finger portions extending in the second horizontal direction from the plurality of contact body portions and being connected to at least some of the plurality of source/drain regions.

### BRIEF DESCRIPTION OF THE DRAWINGS

Features will become apparent to those of skill in the art by describing in detail exemplary embodiments with reference to the attached drawings, in which:
FIG. 1 is a plan view showing an integrated circuit device according to example embodiments;
FIGS. 2A to 2D are cross-sectional views along lines A-A', B-B', C-C', and D-D', respectively, in FIG. 1, showing an integrated circuit device according to example embodiments;
FIGS. 3A to 3D. 4A to 4D, 5A to 5D, 6A to 6D, 7A to 7D, 8A to 8D, 9A to 9D, 10A to 10D, 11A to 11D, and 12A to12D are cross-sectional views along lines A-A', B-B', C-C', and D-D', respectively, in FIG. 1, showing stages in a method of manufacturing an integrated circuit device according to example embodiments;
FIGS. 13A and 13B are cross-sectional views along lines B-B' and C-C', respectively, in FIG. 1, showing an integrated circuit device according to example embodiments; and
FIGS. 14A and 14B are plan views showing integrated circuit devices according to example embodiments.

### DETAILED DESCRIPTION

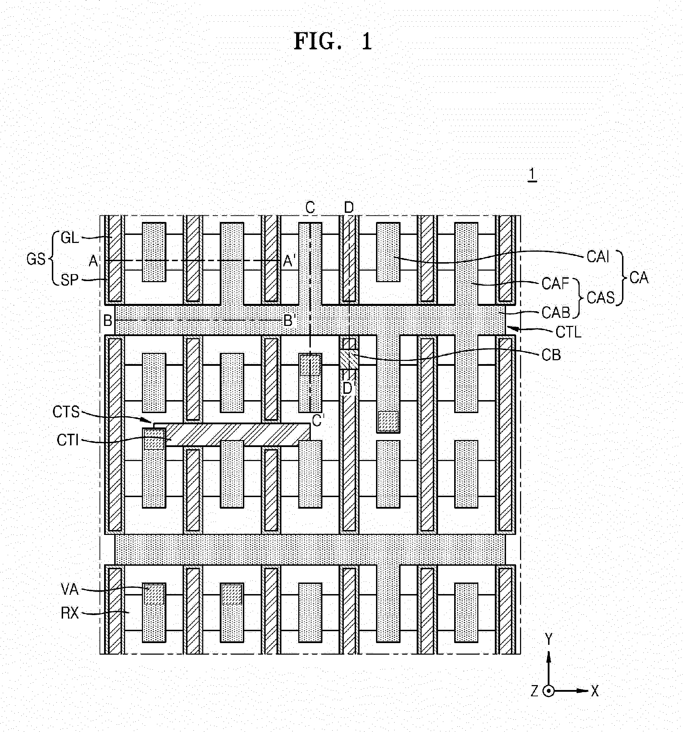

FIG. 1 is a plan view showing an integrated circuit device according to example embodiments. Referring to FIG. 1, an integrated circuit device 1 may include a plurality of device regions RX, which extend in a first horizontal direction (the X direction) and are parallel with each other, and a plurality of gate electrodes GL, which extend in a second horizontal direction (the Y direction) that is orthogonal to the first horizontal direction (the X direction) and are parallel with each other. The gate electrodes GL are located on the plurality of device regions RX. In some embodiments, the gate electrodes GL may be arranged at substantially regular intervals in the first horizontal direction (the X direction). A gate spacer SP may cover the side surfaces of each of the gate electrodes GL. The gate spacer SP may cover the opposite side surfaces in the second horizontal direction (the Y direction) of each gate electrode GL and the opposite side surfaces in the first horizontal direction (the X direction) of the gate electrode GL. According to a top view, the gate spacer SP may completely surround the gate electrode GL. A plurality of gate electrodes GL and a plurality of gate spacers SP respectively corresponding to the gate electrodes GL may form a plurality of gate structures GS. Each of the gate structures GS may include a gate electrode GL extending in the second horizontal direction (the Y direction) and a gate spacer SP covering the side surfaces of the gate electrode GL.

A plurality of first gate cut regions CTL may extend in the first horizontal direction (the X direction) and may be parallel with each other. Each of the first gate cut regions CTL may be between a pair of device regions RX adjacent to each other in the second horizontal direction (the Y direction). In some embodiments, the plurality of device regions RX may be arranged at substantially regular intervals in the second horizontal direction (the Y direction). The first gate cut regions CTL may be arranged among at least some of the device regions RX. In some embodiments, the device regions RX and the first gate cut regions CTL may be arranged at substantially regular intervals in the second horizontal direction (the Y direction). In an implementation, some of a plurality of preliminary device regions formed at substantially regular intervals in the second horizontal direction (the Y direction) may be removed such that the first gate cut regions CTL may be formed, and the other preliminary device regions may remain as the device regions RX.

The first gate cut regions CTL may extend in the first horizontal direction (the X direction) and cut the gate electrodes GL, which extend in the second horizontal direction (the Y direction). One of the first gate cut regions CTL may extend in the first horizontal direction (the X direction) and cut each of the gate electrodes GL, which extend in the second horizontal direction (the Y direction), into two parts. Gate electrodes GL arranged in line in the second horizontal direction (the Y direction) among the plurality of gate electrodes GL may be separated from one another by a plurality of first gate cut regions CTL.

The first gate cut regions CTL may extend in the first horizontal direction (the X direction) and thus cut a plurality of gate electrodes GL in a certain area. In an implementation, each of the first gate cut regions CTL may extend in the first horizontal direction (the X direction) and thus cut all of a plurality of gate electrodes GL that extend across the device regions RX extending in the first horizontal direction (the X direction). The extension length in the first horizontal direction (the X direction) of the first gate cut regions CTL may be the same as or similar to the extension length in the first horizontal direction (the X direction) of the device regions RX.

At least one second gate cut region CTS may extend in the first horizontal direction (the X direction). The second gate cut region CTS may extend in the first horizontal direction (the X direction) and thus cut some of the gate electrodes GL extending in the second horizontal direction (the Y direction). One second gate cut region CTS may extend in the first horizontal direction (the X direction) and cut each of some of the gate electrodes GL, which extends in the second horizontal direction (the Y direction), into two parts. Gate electrodes GL arranged in line in the second horizontal direction (the Y direction) among the plurality of gate electrodes GL may be separated from one another by the first gate cut regions CTL and the second gate cut region CTS. The second gate cut region CTS may be separated from the first gate cut regions CTL.

The second gate cut region CTS may extend in the first horizontal direction (the X direction) and thus cut some gate electrodes GL arranged in a certain area. In an implementation, the second gate cut region CTS may extend in the first horizontal direction (the X direction) and thus cut some of a plurality of gate electrodes GL that extend across the device regions RX extending in the first horizontal direction (the X direction). The extension length in the first horizontal direction (the X direction) of the second gate cut region CTS may be less than the extension lengths in the first horizontal direction (the X direction) of the device regions RX and the first gate cut regions CTL.

A contact body portion CAB may be in each of the first gate cut regions CTL. In some embodiments, the contact body portion CAB may completely fill each of the first gate cut regions CTL. A plurality of contact body portions CAB filling the first gate cut regions CTL may extend in the first horizontal direction (the X direction). The extension length in the first horizontal direction (the X direction) of the contact body portions CAB may be the same as or similar to the extension length in the first horizontal direction (the X direction) of the device regions RX. A contact finger portion CAF may extend in the second horizontal direction (the Y direction) from a contact body portion CAB to be above a portion of a device region RX. In an implementation, a plurality of contact finger portions CAF may extend in the second horizontal direction (the Y direction) from one of the opposite sides in the second horizontal direction (the Y direction) of the contact body portion CAB or may extend in opposite directions of the second horizontal direction (the Y direction and the -Y direction) from both the opposite sides in opposite directions of the second horizontal direction (the Y direction and the -Y direction) of the contact body portion CAB. The contact body portion CAB and the contact finger portion CAF may integrally form a contact structure CAS.

An isolation insulating layer CTI may be in the second gate cut region CTS. The isolation insulating layer CTI may completely fill the second gate cut region CTS.

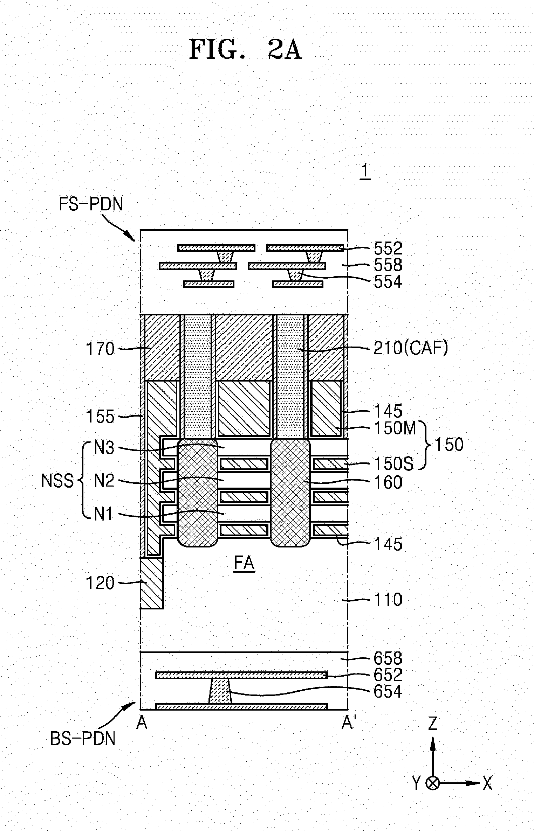

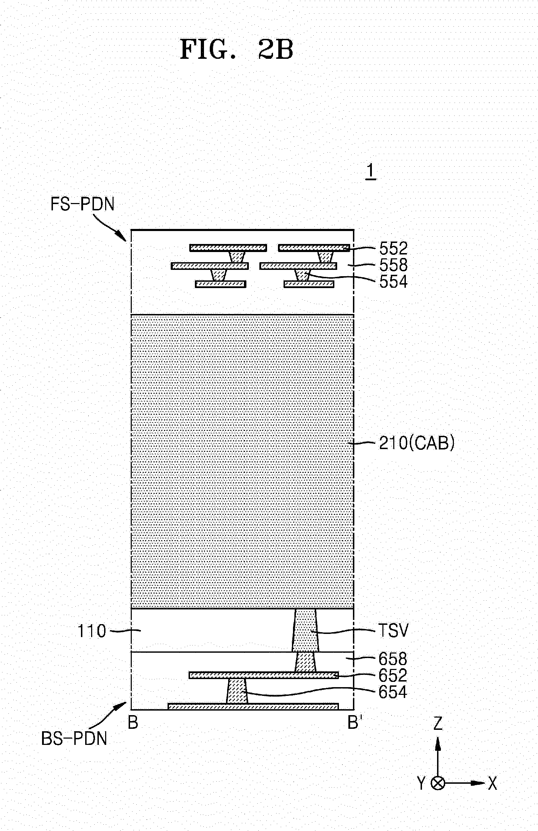

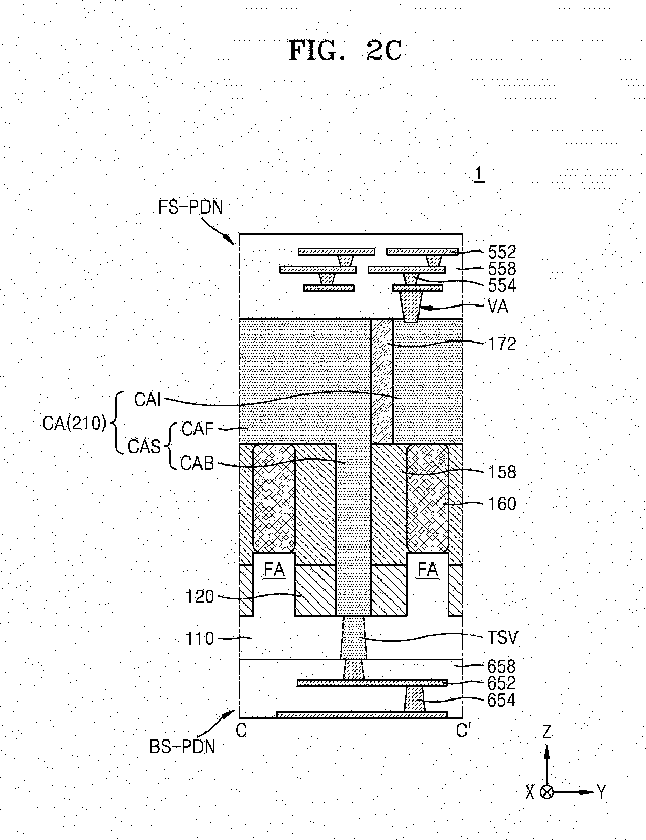

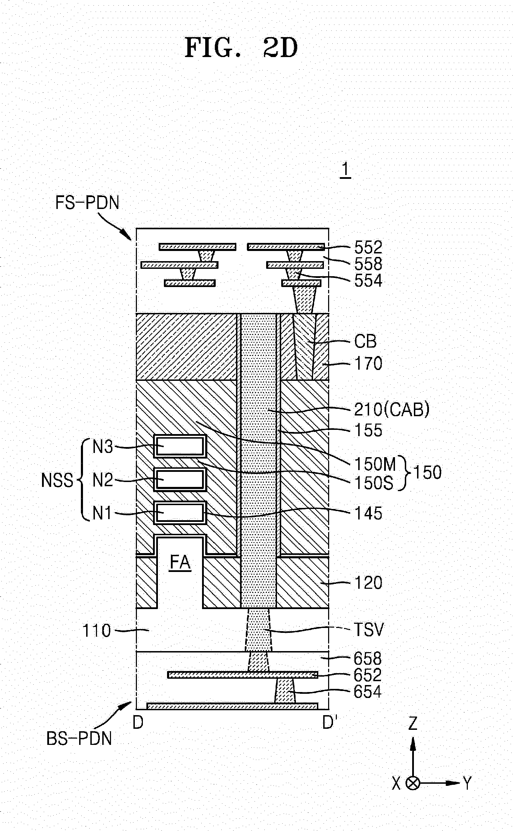

A plurality of source/drain regions 160 (in FIGS. 2A and 2C) may be respectively on a plurality of device regions RX and may be each located between a pair of gate electrodes GL adjacent to each other in the first horizontal direction (the X direction). The contact finger portion CAF or a contact island CAI may be connected to each of the source/drain regions 160. The contact finger portion CAF may be on each of some of the source/drain regions 160, and the contact island CAI may be on each of the other source/drain regions 160. A plurality of contact islands CAI may be separated from each other. The contact islands CAI may be separated from the contact structure CAS. The contact structure CAS and the contact islands CAI may be collectively referred to as a first contact CA. In some embodiments, the integrated circuit device 1 may not include a contact island CAI, and the contact finger portion CAF may be connected to each of the source/drain regions 160. A plurality of gate structures GS may be separated from a plurality of first contacts CA in the first horizontal direction (the X direction). In some embodiments, the gate structures GS and the first contacts CA may be in contact with each other in the first horizontal direction (the X direction). In an implementation, according to a top view, a first contact CA may fill a space between a pair of gate structures GS, which are on a device region RX and adjacent to each other in the first horizontal direction (the X direction).

A via contact VA may be on the contact island CAI. In some embodiments, the via contact VA may be on the contact finger portion CAF. In some embodiments, the via contact VA may not be on the contact structure CAS, which may include the contact body portion CAB and the contact finger portion CAF. Some source/drain regions 160 connected to the contact finger portion CAF may be electrically connected to the contact body portion CAB, and the other source/drain regions 160 connected to the contact island CAI may be electrically connected to the via contact VA. A second contact CB may be on a gate electrode GL. The first contact CA may be referred to as a source/drain contact, and the second contact CB may be referred to as a gate contact.

The via contact VA may be on each of some contact islands CAI, and the second contact CB may be on one gate electrode GL. In some embodiments, the via contact VA may be on each of the contact islands CAI, and the second contact CB may be on each of the gate electrodes GL.

The via contact VA may be only on the contact island CAI but not on the contact finger portion CAF, wherein the contact island CAI and the contact finger portion CAF may be respectively connected to the source/drain regions 160. The contact finger portion CAF may be electrically connected through the contact body portion CAB to a lower wiring structure BS-PDN (in FIGS. 2A to 2D), which may be arranged below the plurality of device regions RX and the plurality of gate electrodes GL for power delivery. Accordingly, the density of an upper wiring structure FS-PDN (in FIGS. 2A to 2D), which may be arranged above the device regions RX and the gate electrodes GL for power delivery, may be reduced in the integrated circuit device 1. Therefore, the design freedom of the integrated circuit device 1 may increase, and reliable power delivery may be possible.

FIGS. 2A to 2D are cross-sectional views showing an integrated circuit device according to example embodiments. In detail, FIGS. 2A to 2D are respectively cross-sectional views taken along lines A-A', B-B', C-C', and D-D', respectively, in FIG. 1.

Referring to FIG. 1 and FIGS. 2A to 2D, the integrated circuit device 1 may include a lower wiring structure BS-PDN, a substrate 110 on the lower wiring structure BS-PDN, a plurality of gate electrodes 150, which extend in the second horizontal direction (the Y direction) that is orthogonal to the first horizontal direction (the X direction) and are parallel with each other, and an upper wiring structure FS-PDN above the gate electrodes 150. The substrate 110 may include a plurality of fin-type active regions FA, which protrude upward in the vertical direction (the Z direction) and extend in the first horizontal direction (the X direction) to be parallel with each other.

In some embodiments, the integrated circuit device 1 may further include a plurality of nanosheet stack structures NSS, which face and are separated from the top surfaces of the fin-type active regions FA. In an implementation, the integrated circuit device 1 may include a multi-gate metal-oxide semiconductor field-effect transistor (MOSFET) constituted of a fin-type active region FA and a nanosheet stack structure NSS. The fin-type active region FA and the nanosheet stack structure NSS may be collectively referred to as a channel region. The channel region may extend in the first horizontal direction (the X direction).

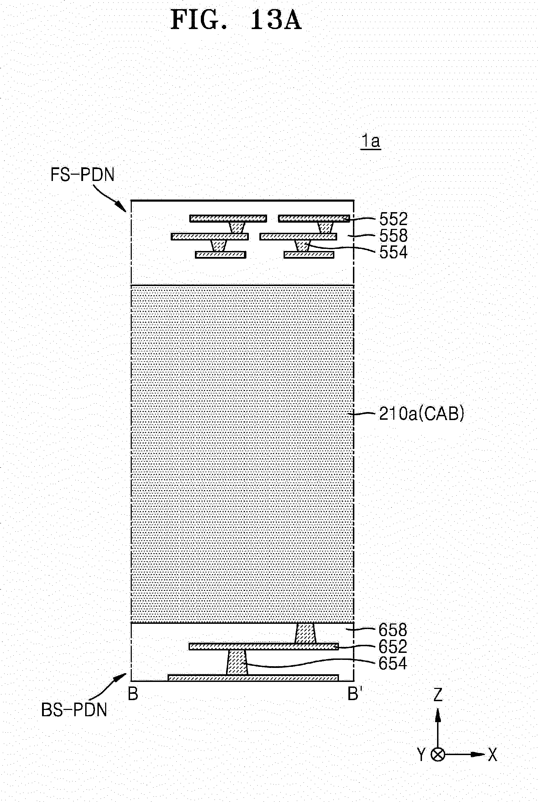

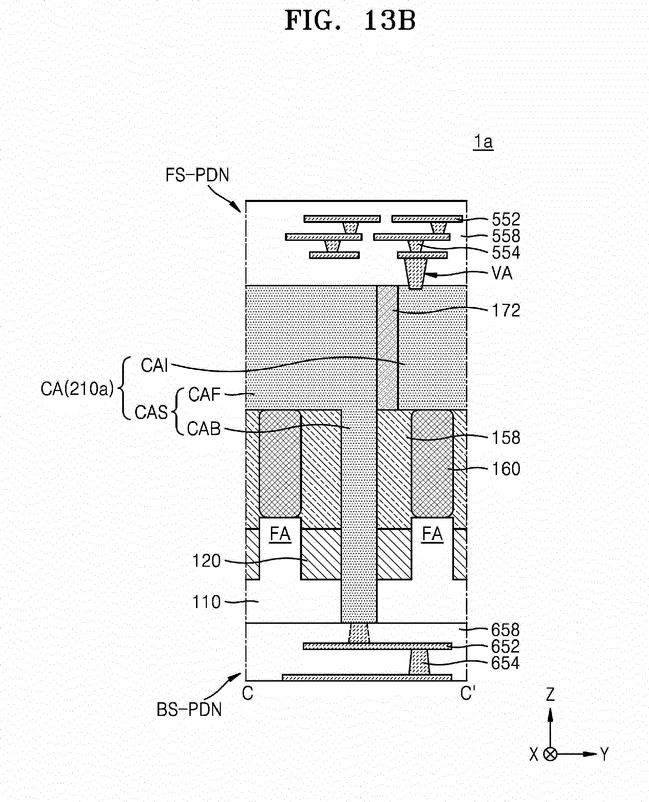

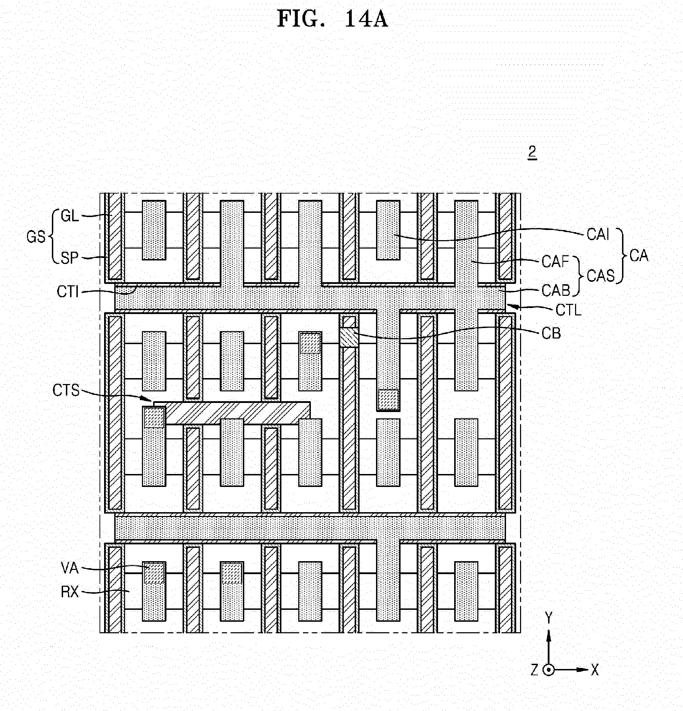

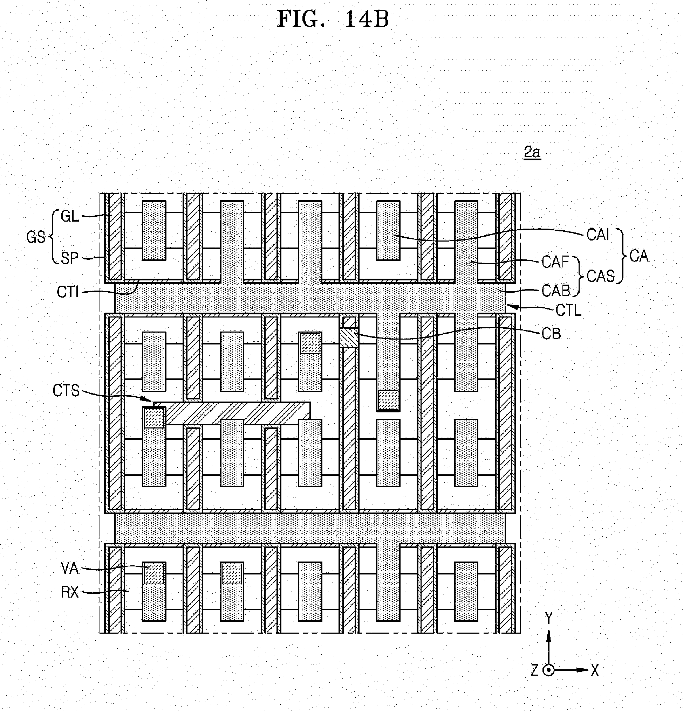

Here, it is described that each of the integrated circuit device 1 of FIGS. 2A to 2D and an integrated circuit device 1a of FIGS. 13A and 13B may include a multi-gate MOSFET. Each of the integrated circuit devices 1 of FIGS. 2A to 2D and the integrated circuit device 1a of FIGS. 13A and 13B may include a single-gate MOSFET constituted of a fin-type active region FA instead of a multi-gate MOSFET constituted of a fin-type active region FA and a nanosheet stack structure NSS. If each of the integrated circuit device 1 of FIGS. 2A to 2D and the integrated circuit device 1a of FIGS. 13A and 13B may include a single-gate MOSFET constituted of a fin-type active region FA instead of a multi-gate MOSFET constituted of a fin-type active region FA and a nanosheet stack structure NSS, the fin-type active region FA may be referred to as a channel region. Each of an integrated circuit device 2 of FIG. 14A and an integrated circuit device 2a of FIG. 14B may include a multi-gate MOSFET or a single-gate MOSFET. The fin-type active region FA or a group of the fin-type active region FA and the nanosheet stack structure NSS may correspond to a device region RX in FIG. 1. As used herein, the term "or" is not an exclusive term, e.g., "A or B" would include A, B, or A and B.

The integrated circuit device 1 may correspond to a logic semiconductor chip. In an implementation, the integrated circuit device 1 may correspond to a central processing unit (CPU) chip, a graphics processing unit (GPU) chip, or an application processor (AP) chip.

Here, the logic semiconductor chip refers to a semiconductor chip that is not a memory semiconductor chip and performs logical operations. In an implementation, the logic semiconductor chip may include a logic cell. In some embodiments, the logic semiconductor chip may include a logic cell and a memory cell. The logic cell may be variously configured to have a plurality of circuit elements, such as a transistor and a register. The logic cell may constitute, e.g., an AND gate, a NAND gate, an OR gate, a NOR gate, an exclusive OR (XOR) gate, an exclusive NOR (XNOR) gate, an inverter (INV), an adder (ADD), a buffer (BUF), a delay (DLY), a filter (FIL), a multiplexer (MXT/MXIT), an OR/AND/inverter (OAI) gate, an AND/OR (AO) gate, an AND/OR/inverter (AOI) gate, a D flip-flop, a reset flip-flop, a master-slave flip-flop, or a latch. The logic cell may constitute a standard cell, such as a counter, which performs a desired logical function.

A plurality of fin-type active regions FA may be defined by an isolation film 120. The isolation film 120 may fill at least a portion of the space between the fin-type active regions FA. In some embodiments, the isolation film 120 may fill a lower portion of the space between the fin-type active regions FA such that the fin-type active regions FA may protrude from the top surface of the isolation film 120 in the vertical direction (the Z direction). In an implementation, the isolation film 120 may be constituted of a material including a silicon oxide film, a silicon nitride film, or a silicon oxynitride film. The isolation film 120 may be constituted of a single layer including one type of insulating film, a double layer including two types of insulating films, or a multi-layer including at least three types of insulating films. In an implementation, the isolation film 120 may be constituted of two different types of insulating films. In an implementation, the isolation film 120 may be constituted of a silicon oxide film and a silicon nitride film. In an implementation, the isolation film 120 may be constituted of a triple-layer of a silicon oxide film, a silicon nitride film, and a silicon oxide film.

A fin-type active region FA may include a semiconductor, such as Si or Ge, or a compound semiconductor, such as SiGe, SiC, GaAs, InAs, or InP. In some embodiments, the fin-type active region FA may include Group III-V materials or Group IV materials. The Group III-V materials may include a binary, ternary, or quaternary compound including at least one Group III element and at least one Group V element. In some embodiments, if an n-type MOS (NMOS) transistor is formed, a plurality of fin-type active regions FA may include one of the Group III-V materials described above. In some embodiments, if a p-type MOS (PMOS) transistor is formed, the fin-type active regions FA may include Ge.

A plurality of nanosheet stack structures NSS may be separated from the top surfaces of a fin-type active region FA in the vertical direction (the Z direction). The nanosheet stack structures NSS may include a plurality of nanosheets N1, N2, and N3, which extend in parallel with the top surface of the fin-type active region FA.

The nanosheets N1, N2, and N3 constituting a nanosheet stack structure NSS may be sequentially stacked above the top surface of the fin-type active region FA. A single nanosheet stack structure NSS may include three nanosheets N1, N2, and N3. In an implementation, the nanosheets N1, N2, and N3 may be constituted of a single material. In some embodiments, the nanosheets N1, N2, and N3 may be constituted of the same material as the fin-type active region FA.

A plurality of gate electrodes 150 may be parallel with each other on the fin-type active region FA and may extend in the second horizontal direction (the Y direction) that is orthogonal to the first horizontal direction (the X direction). The gate electrodes 150 may at least partially overlap with the fin-type active regions FA and the nanosheet stack structures NSS in the vertical direction (the Z direction).

Each of the gate electrodes 150 may cover a nanosheet stack structure NSS and surround at least some of the nanosheets N1, N2, and N3. A gate electrode 150 may include a main gate portion 150M, which covers the top surfaces of the fin-type active region FA and the nanosheet stack structure NSS and the side surface of the nanosheet stack structure NSS, and a plurality of sub gate portions 150S, which may be connected to the main gate portion 150M and formed in the spaces between the fin-type active region FA and the nanosheets N1, N2, and N3, e.g., respectively below the nanosheets N1, N2, and N3. A gate insulating film 145 may be formed between the fin-type active region FA and the gate electrode 150, between the nanosheet stack structure NSS and the gate electrode 150, and between a source/drain region 160 and the gate electrode 150.

The gate insulating film 145 may include a silicon oxide film, or a high-k dielectric film. The high-k dielectric film may include a material having a higher dielectric constant than a silicon oxide film. In an implementation, the high-k dielectric film may have a dielectric constant of about 10 to about 25. The high-k dielectric film may include metal oxide or metal oxynitride. The high-k dielectric film may include hafnium oxide, hafnium oxynitride, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, or lead zinc niobate.

The high-k dielectric film may be formed by using atomic layer deposition (ALD), chemical vapor deposition (CVD), or physical vapor deposition (PVD). The high-k dielectric film may have a thickness of about 10 Å to about 40 Å. In some embodiments, the gate insulating film 145 may have a stack structure of an interfacial layer and the high-k dielectric film. The interfacial layer may include a low-k dielectric material having a permittivity of about 9 or less.

In some embodiments, the interfacial layer may include a silicon oxide film, or a silicon oxynitride film. In some embodiments, the interfacial layer may be omitted.

The gate electrode 150 may include a work function metal layer and a gap-fill metal layer filling a space above the work function metal layer. The work function metal layer may include Ti, W, Ru, Nb, Mo, Hf, Ni, Co, Pt, Yb, Tb, Dy, Er, or Pd. In some embodiment, the gate electrode 150 may have a structure in which a metal nitride layer, a metal layer, a conductive capping layer, and a gap-fill metal film are sequentially stacked. The metal nitride layer and the metal layer may include Ti, Ta, W, Ru, Nb, Mo, or Hf. The gap-fill metal film may include a W film or an Al film. In some embodiments, a gate electrode 150 may have a stack structure of TiAlC/TiN/W, a stack structure of TiN/TaN/TiAlC/TiN/W, or a stack structure of TiN/TaN/TiN/TiAlC/TiNAV.

A plurality of gate capping layers 170 may be respectively on a plurality of gate electrodes 150. The gate capping layers 170 may respectively cover the gate electrodes 150. The gate capping layers 170 may include nitride.

A gate spacer 155 may cover the side surfaces of a gate electrode 150 and the side surface of a gate capping layer 170. In some embodiments, the gate spacer 155 may cover the side surfaces of the gate electrode 150 with the gate insulating film 145 between the gate spacer 155 and the gate electrode 150. The gate electrode 150 may correspond to a gate electrode GL in FIG. 1 and the gate spacer 155 may correspond to a gate spacer SP in FIG. 1. The gate electrode GL may be in direct contact with the gate spacer SP. The gate insulating film 145 may be between the gate electrode GL and the gate spacer SP in FIG. 1. The topmost end of the gate capping layer 170 may be at the same vertical level as the topmost end of the gate spacer 155. The topmost end of the gate electrode 150 may be at the same vertical level as the topmost end of the gate insulating film 145. In some embodiments, the topmost end of the gate insulating film 145 may be at a higher vertical level than the topmost end of the gate electrode 150 and may be at a vertical level that is the same as or lower than the vertical level of the topmost end of the gate capping layer 170.

The gate spacer 155 may cover the opposite side surfaces in the second horizontal direction (the Y direction) and the opposite side surfaces in the first horizontal direction (the X direction) of the gate electrode 150. According to a top view, the gate spacer 155 may completely surround the gate electrode 150. The gate electrode 150, the gate capping layer 170, the gate insulating film 145, and the gate spacer 155 may constitute a gate structure GS. The gate spacer 155 may include silicon nitride. The gate spacer 155 may be constituted of a single layer or a stack structure of at least two layers.

The gate electrode 150 may be formed by using a replacement metal gate (RMG) process. In an implementation, after a dummy insulating film and a dummy gate electrode are formed on the fin-type active region FA, the gate spacer 155 may surround the dummy gate electrode. Thereafter, the dummy insulating film and the dummy gate electrode may be removed, and the gate insulating film 145 and the gate electrode 150 may be formed in the space surrounded by the gate spacer 155.

A plurality of source/drain regions 160 may be respectively formed on a plurality of fin-type active regions FA. Each of the source/drain regions 160 may be connected to an end of each of the nanosheets N1, N2, and N3 adjacent thereto. Each of the source/drain regions 160 may be formed on a portion of one of a plurality of fin-type active regions FA between a pair of gate electrodes GL adjacent to each other in the first horizontal direction (the X direction).

In some embodiments, a source/drain region 160 in the case of forming an NMOS transistor and a source/drain region 160 in the case of forming a PMOS transistor may include different materials from each other and may be formed by performing separate epitaxial growth processes. In some embodiments, the source/drain region 160 may include Ge. In an implementation, the source/drain region 160 may have a multi-layer structure, which may include a semiconductor material including Si and a semiconductor material including Ge. In some embodiments, the source/drain region 160 may include Si but not Ge. In an implementation, the source/drain region 160 may include a semiconductor material including Si or may have a multi-layer structure, which may include a semiconductor material such as Si and a compound semiconductor such as SiC.

In some embodiments, the source/drain region 160 may extend through the top surface of a fin-type active region FA into the inside thereof. In some embodiments, the source/drain region 160 may extend through the top surface of the fin-type active region FA into the inside thereof but not to the bottom surface thereof.

An intergate insulating layer 158 may fill the space between the plurality of gate structures GS. In some embodiments, the intergate insulating layer 158 may fill the space between the gate structures GS and surround the plurality of source/drain regions 160. The intergate insulating layer 158 may include a silicon oxide film. In some embodiments, the intergate insulating layer 158 may have a stack structure of at least two layers including a first layer constituted of silicon nitride and a second layer constituted of silicon oxide. The intergate insulating layer 158 may be between a contact body portion CAB and the source/drain regions 160, the intergate insulating layer 158 may be between a contact finger portion CAF, a contact island CAI, a gate capping layer 170, and an isolation capping layer 172.

A first contact 210 or CA may include a contact structure CAS and the contact island CAI. In some embodiments, the first contact 210 or CA may include only the contact structure CAS but not the contact island CAI. The contact structure CAS may include the contact body portion CAB and the contact finger portion CAF. The contact body portion CAB and the contact finger portion CAF may be integrally connected to each other. The contact structure CAS may be separated from the gate electrode 150 by the gate spacer 155. In some embodiments, the first contact 210 or CA may include a conductive barrier layer and a conductive core layer covering the conductive barrier layer. The conductive barrier layer may include Ti, Ta, TiN, or TaN. The conductive core layer may include Co, W, or Cu. The first contact 210 or CA may pass through the gate capping layer 170 and the intergate insulating layer 158.

The plurality of contact body portions CAB may respectively be in the plurality of first gate cut regions CTL. In some embodiments, the contact body portions CAB may completely fill the first gate cut regions CTL. Each of the contact body portions CAB may extend in the first horizontal direction (the X direction) and each of the plurality of contact finger portions CAF may extend in the second horizontal direction (the Y direction) from a contact body portion CAB connected thereto. Each of the contact finger portions CAF may be in contact with the top surface of a source/drain region 160 and may extend in the second horizontal direction (the Y direction) to be connected to the contact body portion CAB. The contact body portion CAB may extend from the top surfaces of the intergate insulating layer 158 and the source/drain region 160 toward the substrate 110 through the intergate insulating layer 158. In an implementation, the contact body portion CAB may extend from a higher vertical level than the top surface of the source/drain region 160 toward the substrate 110 in the vertical direction (the Z direction). The contact body portion CAB may pass through the intergate insulating layer 158 and the isolation film 120 and may extend to the top surface of the substrate 110. In some embodiments, the contact body portion CAB may pass through the intergate insulating layer 158 and the isolation film 120 and extend inside the substrate 110. The contact body portion CAB may have a plate shape extending in the first horizontal direction (the X direction) and the vertical direction (the Z direction).

The plurality of contact body portions CAB may extend in the first horizontal direction (the X direction) and may be parallel with each other. Each of the contact body portions CAB may be between a pair of fin-type active regions FA adjacent to each other in the second horizontal direction (the Y direction). The contact body portions CAB may extend in the first horizontal direction (the X direction) and thus cut the plurality of gate electrodes 150 extending in the second horizontal direction (the Y direction). One contact body portion CAB may extend in the first horizontal direction (the X direction) and cut each of the gate electrodes 150, which extend in the second horizontal direction (the Y direction), into two parts. Gate electrodes 150 arranged in line in the second horizontal direction (the Y direction) among the plurality of gate electrodes 150 may be separated from one another by the plurality of contact body portions CAB. The gate spacer 155 may be between a gate structure GS and a contact body portion CAB such that the gate structure GS and the contact body portion CAB may be separated and electrically insulated from each other. In an implementation, the gate insulating film 145 and the gate spacer 155 may be between a gate electrode 150 and a contact body portion CAB. The gate spacer 155 may electrically insulate the gate electrode 150 from the contact body portion CAB. In some embodiments, a side portion of the contact body portion CAB, which may not be connected to the contact finger portion CAF, may be covered with the gate spacer 155 and the intergate insulating layer 158.

The contact finger portion CAF may extend in the second horizontal direction (the Y direction) from the contact body portion CAB to the top surface of the source/drain region 160. In an implementation, a plurality of contact finger portions CAF may extend in the second horizontal direction (the Y direction) from one of the opposite sides in the second horizontal direction (the Y direction) of the contact body portion CAB or may extend in opposite directions of the second horizontal direction (the Y direction and the -Y direction) from both the opposite sides in opposite directions of the second horizontal direction (the Y direction and the -Y direction) of the contact body portion CAB. The top surface of the contact body portion CAB may be at the same vertical level as the top surface of each of the contact finger portions CAF. The bottom surface of the contact body portion CAB may be at a lower vertical level than the bottom surface of each contact finger portion CAF. The bottom surface of the contact finger portion CAF may be in contact with the top surface of the source/drain region 160. The contact finger portion CAF may extend from an upper portion of the contact body portion CAB to the top surface of the source/drain region 160 and thus be connected to the source/drain region 160. In some embodiments, the opposite side surfaces in the first horizontal direction (the X direction) of the contact finger portion CAF may be covered with the gate spacer 155. The gate insulating film 145 and the gate spacer 155 may be between the gate electrode 150 and the contact finger portion CAF. The gate spacer 155 may electrically insulate the contact finger portion CAF from the gate electrode 150.

The contact finger portion CAF or the contact island CAI may be connected to each of the plurality of source/drain regions 160. The contact finger portion CAF may be on each of some of the source/drain regions 160 and the contact island CAI may be on each of the other source/drain regions 160. In some embodiments, a metal silicide film may be between each of the source/drain regions 160 and either of the contact finger portion CAF or the contact island CAI.

The contact island CAI may be separated from the contact structure CAS and may extend in the second horizontal direction (the Y direction). The isolation capping layer 172 may be between the contact body portion CAB and the contact island CAI. The isolation capping layer 172 may include nitride. In some embodiments, the isolation capping layer 172 may include the same material as the gate capping layer 170. The contact island CAI may extend in the second horizontal direction (the Y direction) from the isolation capping layer 172 to the top surface of the source/drain region 160. The top surface of the contact body portion CAB may be at the same vertical level as the top surface of the contact island CAI. The bottom surface of the contact body portion CAB may be at a lower vertical level than the bottom surface of the contact island CAI. The bottom surface of the contact island CAI may be in contact with the top surface of the source/drain region 160. In some embodiments, the bottom surface of the contact finger portion CAF may be at the same vertical level as the bottom surface of the contact island CAI. In some embodiments, the respective top surfaces of the contact body portion CAB, the contact finger portion CAF, the contact island CAI, the gate capping layer 170, and the isolation capping layer 172 may be at the same vertical level as one another and thus be coplanar with one another.

A second contact CB may be connected to the gate electrode 150. The second contact CB may pass through the gate capping layer 170 to be connected to the gate electrode 150. The second contact CB may include metal, or conductive metal nitride.

The upper wiring structure FS-PDN may be on the contact body portion CAB, the contact finger portion CAF, the contact island CAI, the gate capping layer 170, and the isolation capping layer 172. The lower wiring structure BS-PDN may be below the substrate 110.

The upper wiring structure FS-PDN may include a plurality of upper wiring lines 552, a plurality of upper wiring vias 554 each connected to at least one of the upper wiring lines 552, and an upper inter-wiring insulation layer 558 surrounding the upper wiring lines 552 and the upper wiring vias 554. Each of some of the upper wiring vias 554 may electrically connect upper wiring lines 552, which may be at different vertical levels, e.g., in different wiring layers, from each other among the plurality of upper wiring lines 552. Among the upper wiring vias 554, at least one bottommost upper wiring via 554 may be electrically connected to the contact island CAI. If a structure including an insulating material is between the upper wiring structure FS-PDN and each of the contact body portion CAB, the contact finger portion CAF, the contact island CAI, the gate capping layer 170, and the isolation capping layer 172, the via contact VA may pass through the insulating material of the structure, and at least one bottommost upper wiring via 554 may be electrically connected to the via contact VA. At least one other bottommost upper wiring via 554 among the plurality of upper wiring vias 554 may be electrically connected to the second contact CB.

The lower wiring structure BS-PDN may include a plurality of lower wiring lines 652, a plurality of lower wiring vias 654 each connected to at least one of the lower wiring lines 652, and a lower inter-wiring insulation layer 658 surrounding the lower wiring lines 652 and the lower wiring vias 654. In some embodiments, if the lower wiring lines 652 are arranged in at least two wiring layers, each of some of the lower wiring vias 654 may electrically connect lower wiring lines 652, which may be at different vertical levels, e.g., in different wiring layers, from each other among the plurality of lower wiring lines 652.

A wiring layer may refer to an electrical path extending on a plane at the same vertical level. In some embodiments, the upper wiring structure FS-PDN may have more wiring layers than the lower wiring structure BS-PDN. In an implementation, the upper wiring structure FS-PDN may have at least three wiring layers and the lower wiring structure BS-PDN may have at least two wiring layers. The thickness in the vertical direction (the Z direction) of the upper wiring structure FS-PDN may be greater than the thickness in the vertical direction (the Z direction) of the lower wiring structure BS-PDN.

A through electrode TSV may extend from the bottom surface of the substrate 110 to the inside of the substrate 110. The through electrode TSV may be in contact with and connected to the contact body portion CAB. In some embodiments, the through electrode TSV may extend from the bottom surface to the top surface of the substrate 110 to be in contact with the contact body portion CAB. In some embodiments, the through electrode TSV may extend from the bottom surface of the substrate 110 to the inside of the substrate 110 but not to the top surface of the substrate 110 and the contact body portion CAB may extend to the inside of the substrate 110 to be in contact with and connected to the through electrode TSV. The through electrode TSV may electrically connect the contact body portion CAB to the lower wiring vias 654 and the lower wiring lines 652.

In an implementation, the lower wiring lines 652, the lower wiring vias 654, the upper wiring lines 552, and the upper wiring vias 554 may include a metal material, such as copper (Cu), aluminum (Al), or tungsten (W). The lower inter-wiring insulation layer 658 and the upper inter-wiring insulation layer 558 may include an insulating material, such as a high density plasma (HDP) oxide film, a tetraethyl orthosilicate (TEOS) oxide film, tonen silazene (TOSZ), spin-on-glass (SOG), undoped silica glass (USG), or a low-k dielectric layer.

The plurality of source/drain regions 160 may be electrically connected to the lower wiring vias 654 and the lower wiring lines 652 of the lower wiring structure BS-PDN through the plurality of contact body portions CAB, which are respectively in the plurality of first gate cut regions CTL cutting the plurality of gate electrodes GL or 150 extending in the second horizontal direction (the Y direction). Accordingly, a separate space for forming the contact body portions CAB electrically connected to the lower wiring structure BS-PDN may not be necessary, and therefore, the integration density of the integrated circuit device 1 may increase and a power delivery network allowing reliable power delivery may be formed in the integrated circuit device 1.

A contact body portion CAB may be integrally formed with a plurality of contact finger portions CAF corresponding thereto, thereby simplifying manufacturing processes and reducing manufacturing cost.

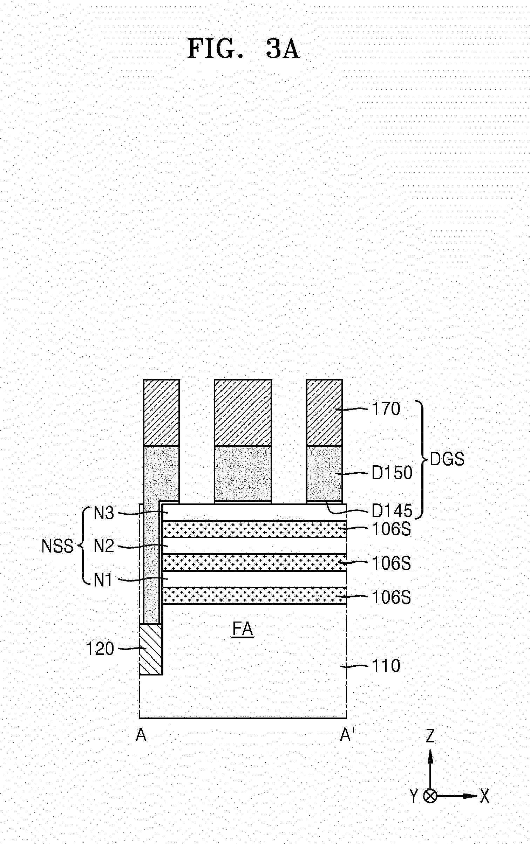

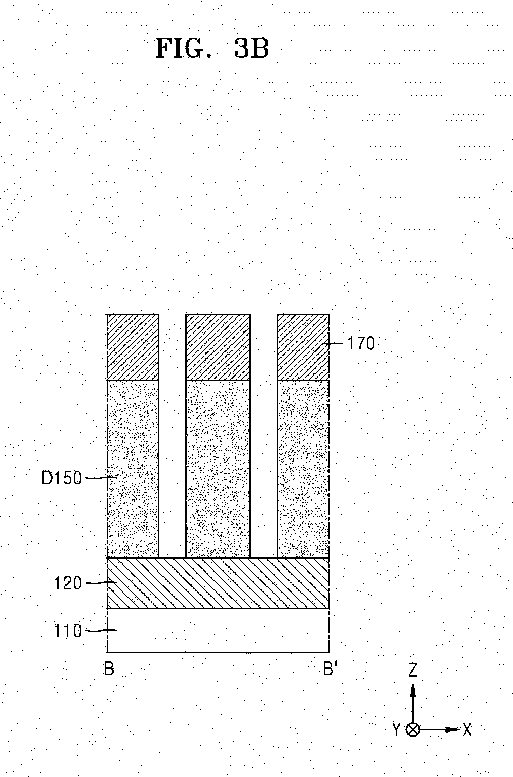

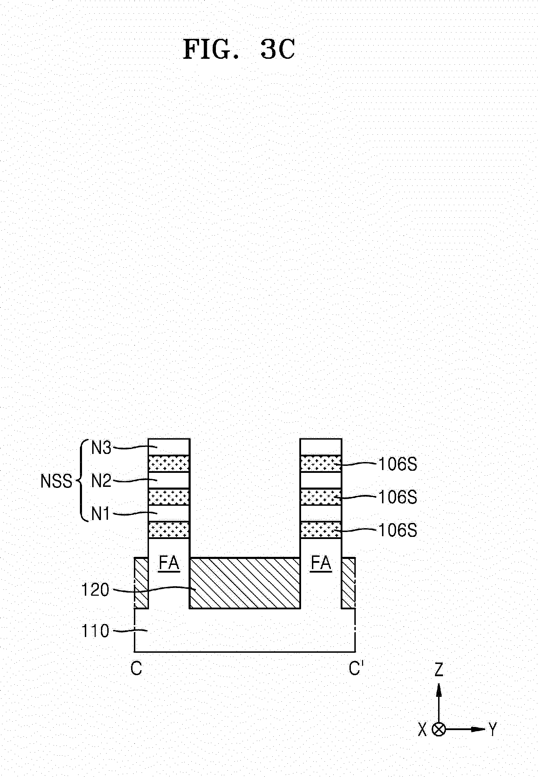

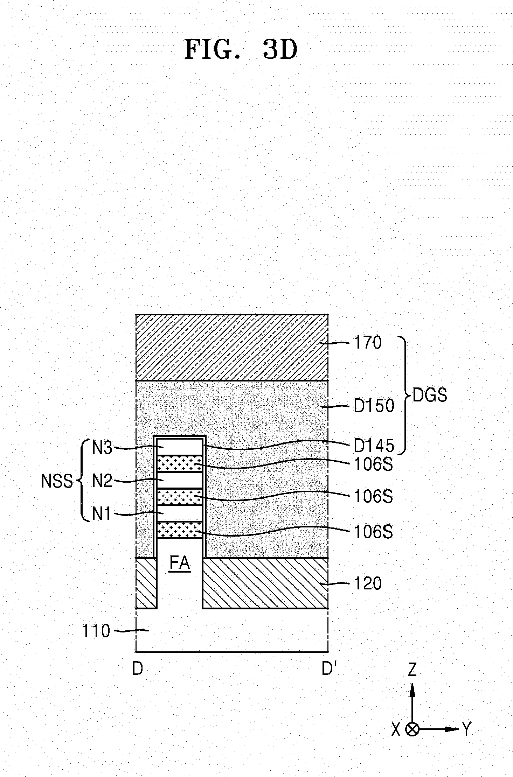

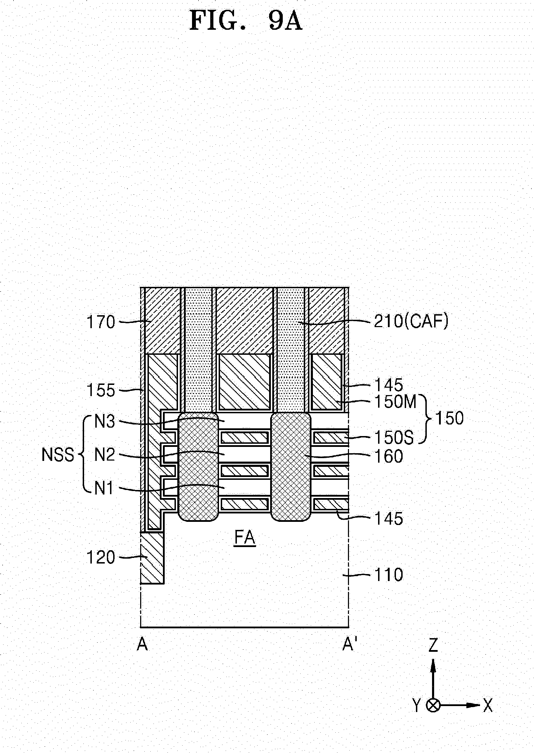

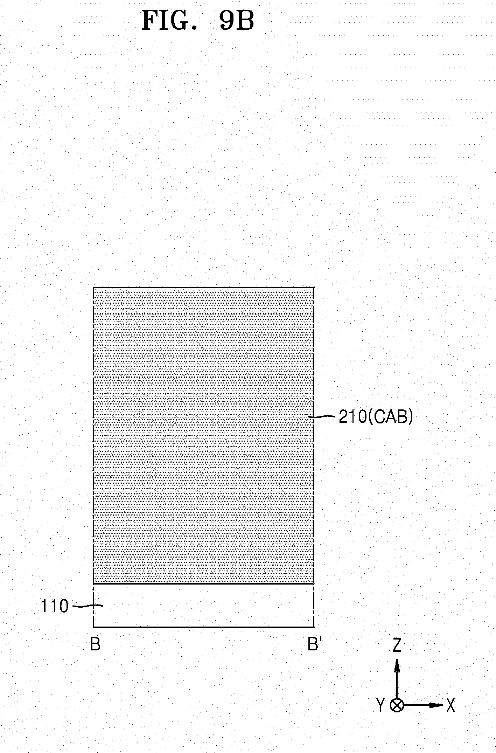

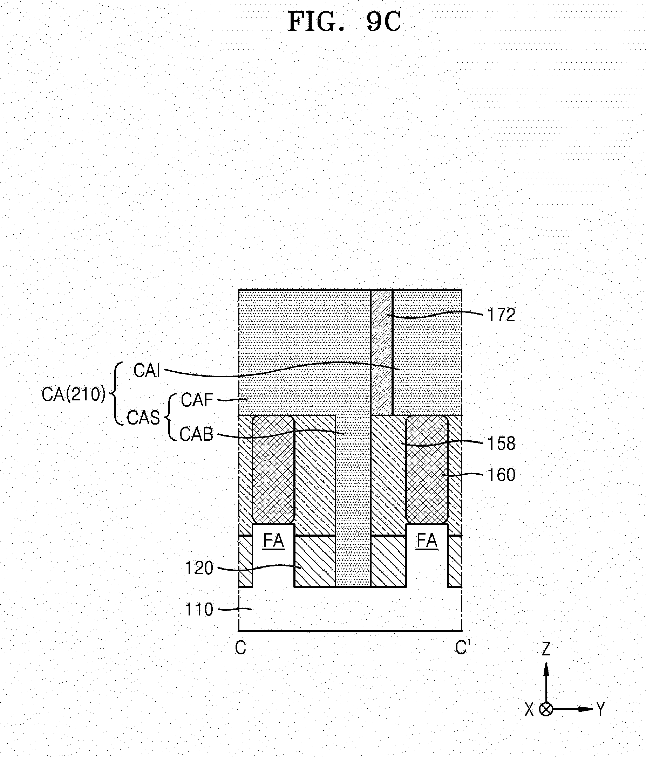

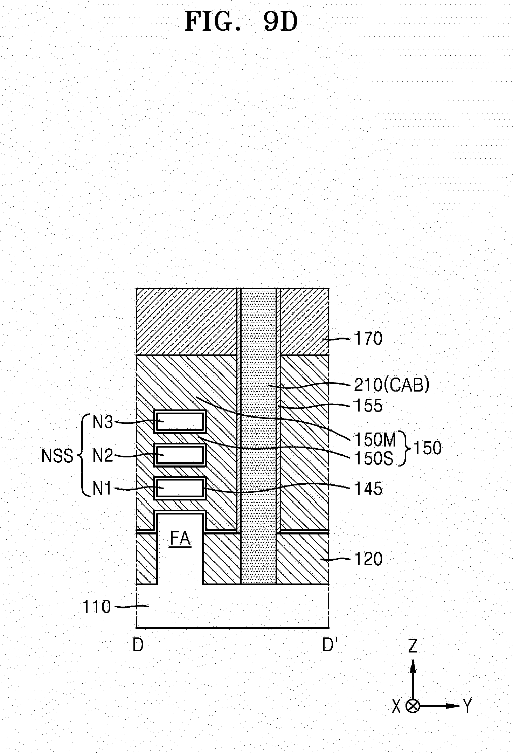

FIGS. 3A to 12D are cross-sectional views showing stages in a method of manufacturing an integrated circuit device according to example embodiments. FIGS. 3A to 12D illustrate a method of manufacturing the integrated circuit device 1 in FIGS. 1 to 2D. FIGS. 1 to 2D may also be referred to together with FIGS. 3A to 12D. FIGS. 3A, 4A, 5A, 6A, 7A, 8A, 9A, 10A, 11A, and 12A are cross-sectional views taken along line A-A' in FIG. 1. FIGS. 3B, 4B, 5B, 6B, 7B, 8B, 9B, 10B, 11B, and 12B are cross-sectional views taken along line B-B' in FIG. 1. FIGS. 3C, 4C, 5C, 6C, 7C, 8C, 9C, 10C, 11C, and 12C are cross-sectional views taken along line C-C' in FIG. 1. FIGS. 3D, 4D, 5D, 6D, 7D, 8D, 9D, 10D, 11D, and 12D are cross-sectional views taken along line D-D' in FIG. 1.

Referring to FIGS. 3A to 3D, a plurality of sacrificial semiconductor layers 106S and a plurality of nanosheet semiconductors may be alternately stacked on the substrate 110. The sacrificial semiconductor layers 106S may include a different semiconductor material than the nanosheet semiconductor layers. In some embodiments, the nanosheet semiconductor layers may be constituted of a single material. In some embodiments, the nanosheet semiconductor layers may include the same material as the substrate 110. In some embodiments, the sacrificial semiconductor layers 106S may include SiGe and the nanosheet semiconductor layers may include Si.

The sacrificial semiconductor layers 106S may have the same thickness. In some embodiments, the thickness of a sacrificial semiconductor layer 106S nearest to the substrate 110 among the sacrificial semiconductor layers 106S may be greater than the thicknesses of the other sacrificial semiconductor layers 106S.

The substrate 110 may include a semiconductor, such as Si or Ge, or a compound semiconductor, such as SiGe, SiC, GaAs, InAs, or InP. In some embodiments, the substrate 110 may include Group III-V materials and Group IV materials. The Group III-V materials may include a binary, ternary, or quaternary compound including at least one Group III element and at least one Group V element. In some embodiments, if an NMOS transistor is formed in a portion of the substrate 110, the portion of the substrate 110 may include one of the Group III-V materials described above. In some embodiments, if a PMOS transistor is formed in a portion of the substrate 110, the portion of the substrate 110 may include Ge. Alternatively, the substrate 110 may have a semiconductor-on-insulator (SOI) structure. The substrate 110 may include a conductive region, e.g., an impurity-doped well or an impurity-doped structure.

A plurality of fin-type active regions FA may be formed on the substrate 110 by partially etching a stack structure of the sacrificial semiconductor layers 106S and the nanosheet semiconductor layers and the substrate 110. The fin-type active regions FA may protrude upward in the vertical direction (the Z direction) from the main surface of the substrate 110. The fin-type active regions FA may be arranged at the same pitch in the second horizontal direction (the Y direction).

The sacrificial semiconductor layers 106S and a stack structure NSS of a plurality of nanosheets N1, N2, and N3 may be on each of the fin-type active regions FA. The stack structure NSS of the nanosheets N1, N2, and N3 may be formed by partially etching the nanosheet semiconductor layers.

An isolation film 120 may fill at least a portion of the space between the fin-type active regions FA. In some embodiments, the isolation film 120 may fill a lower portion of the space between the fin-type active regions FA. The fin-type active regions FA may protrude from the top surface of the isolation film 120 in the vertical direction (the Z direction). In an implementation, the isolation film 120 may be constituted of a material including a silicon oxide film, a silicon nitride film, or a silicon oxynitride film.

A plurality of dummy gate structures DGS may be formed above each of the fin-type active regions FA, on which the stack structure NSS of the nanosheets N1, N2, and N3 and the sacrificial semiconductor layers 106S are formed, to cross at least a portion of each fin-type active region FA. Each of the dummy gate structures DGS may include a dummy insulating film D145, a dummy gate electrode D150, and a gate capping layer 170. The dummy gate structures DGS may extend in the second horizontal direction (the Y direction) and may be parallel with each other.

The dummy insulating film D145, the dummy gate electrode D150, and the gate capping layer 170 may be sequentially formed to cover the exposed surfaces of the stack structure NSS of the nanosheets N1, N2, and N3 and the sacrificial semiconductor layers 106S, which cover the fin-type active region FA, the exposed surface of the fin-type active region FA, and the top surface of the isolation film 120 and may then be patterned, thereby forming the dummy gate structures DGS. In some embodiments, the dummy insulating film D145 may include oxide, the dummy gate electrode D150 may include polysilicon, and the gate capping layer 170 may include nitride.

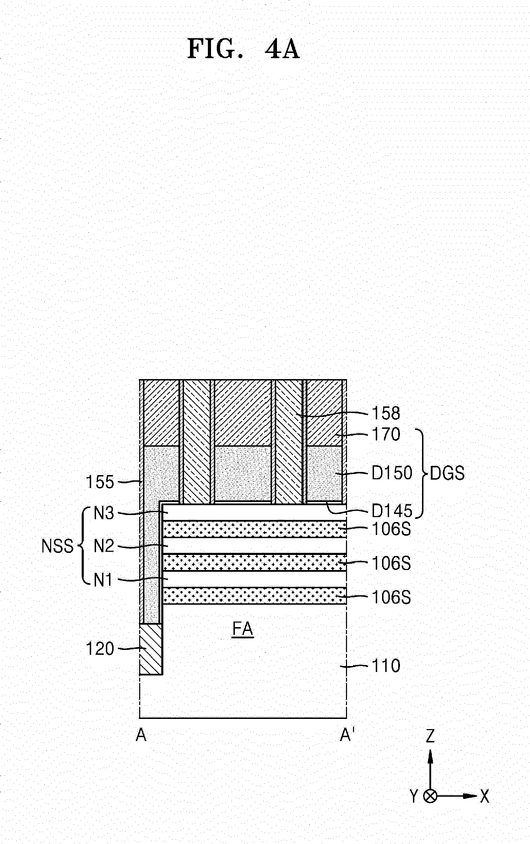

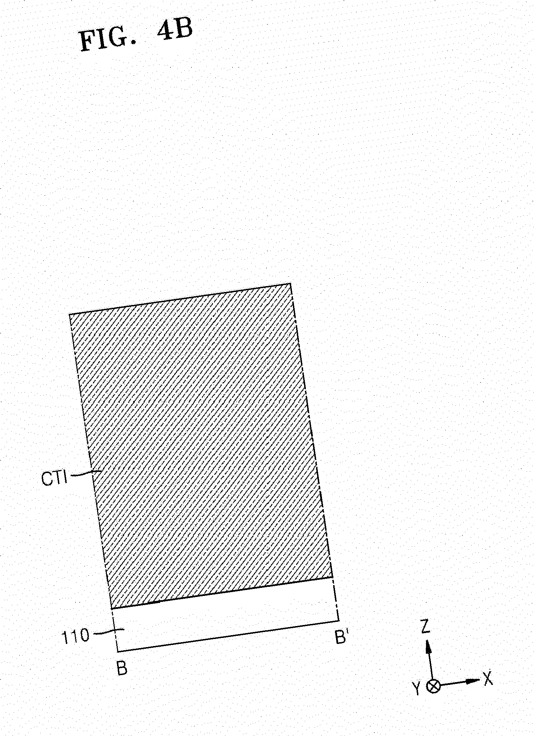

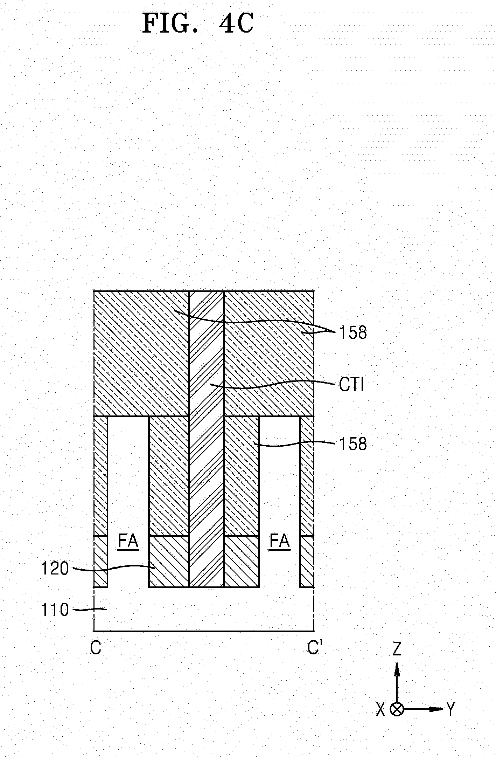

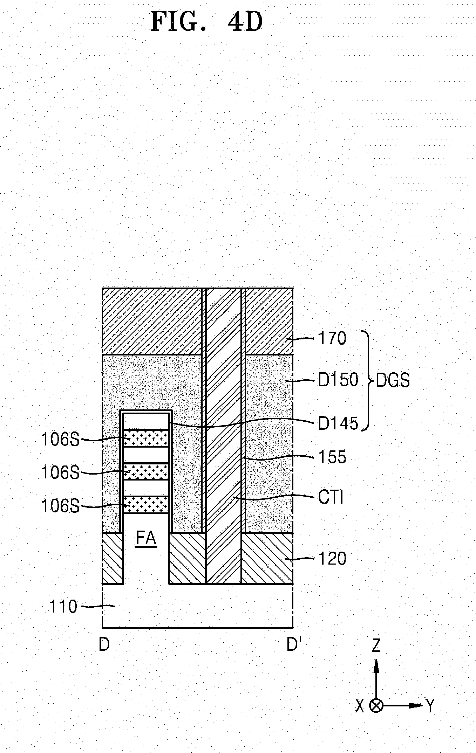

Referring to FIGS. 4A to 4D, the dummy gate structures DGS respectively arranged in portions respectively corresponding to the first gate cut regions CTL in FIG. 1 may be partially removed such that each of the dummy gate structures DGS in FIGS. 3A to 3D is divided into a plurality of parts in the second horizontal direction (the Y direction). Thereafter, a gate spacer 155 may cover the side surfaces of each of the divided parts of the dummy gate structures DGS and thus surround each divided part. In an implementation, the gate spacer 155 may include silicon nitride. A portion corresponding to each of the first gate cut regions CTL in FIG. 1 may be filled with an isolation insulating layer CTI. In some embodiments, at least a portion between the dummy gate structures DGS may be filled with an intergate insulating layer 158. In some embodiments, if distinction between the isolation insulating layer CTI and the intergate insulating layer 158 is not clear because the isolation insulating layer CTI and the intergate insulating layer 158 may be constituted of the same or similar materials, the isolation insulating layer CTI may be a part of the intergate insulating layer 158 or the intergate insulating layer 158 may be a part of the isolation insulating layer CTI.

In some embodiments, a plurality of dummy gate structures DGS in a portion corresponding to the second gate cut region CTS in FIG. 1 may also be partially removed and the portion corresponding to the second gate cut region CTS may also be filled with the isolation insulating layer CTI.

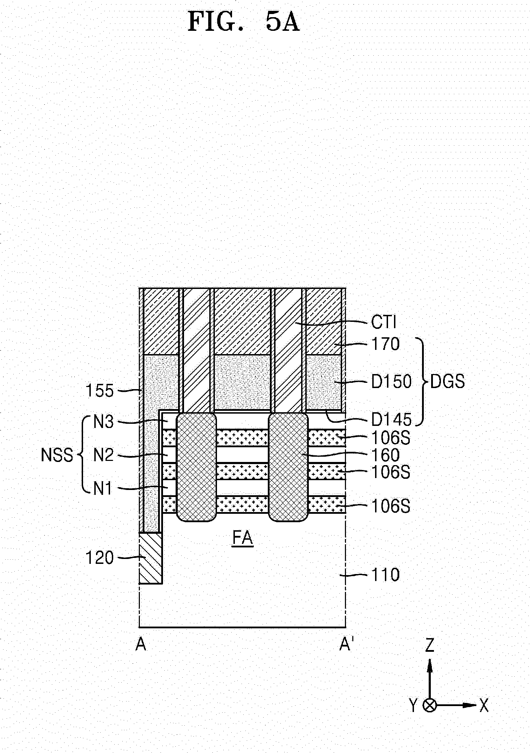

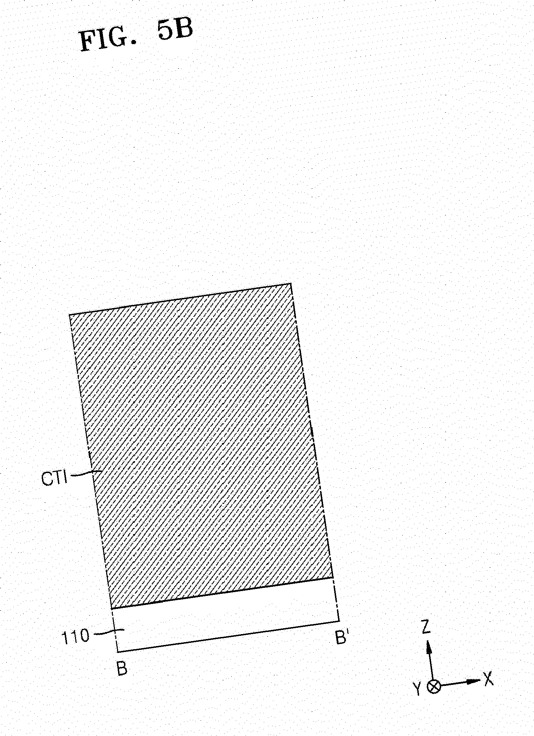

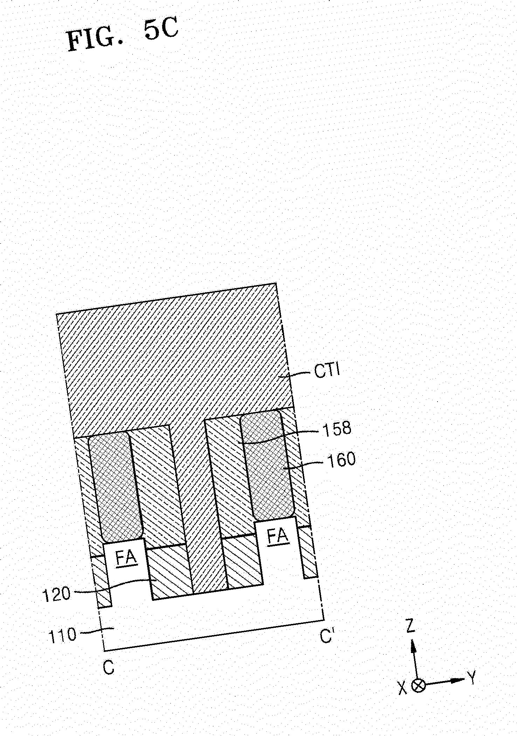

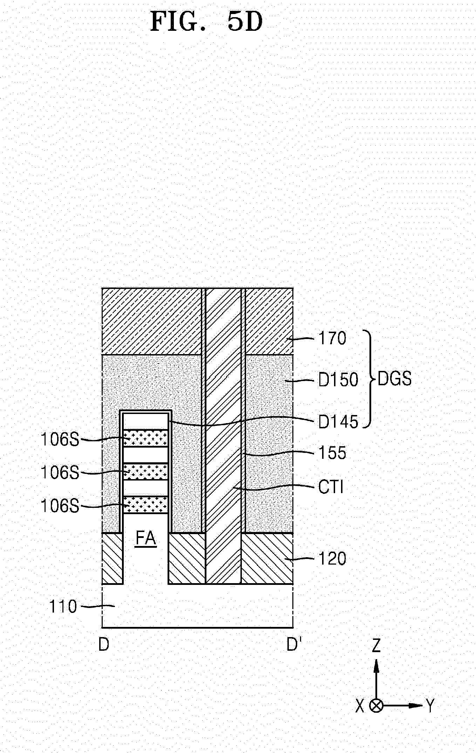

Referring to FIGS. 4A to 4D and FIGS. 5A to 5D, a portion of the isolation insulating layer CTI, a portion of the stack structure NSS of the nanosheets N1, N2, and N3, and a portion of each of the sacrificial semiconductor layers 106S may be removed to expose a portion of each of a plurality of fin-type active regions FA between a pair of dummy gate structures DGS adjacent to each other in the first horizontal direction (the X direction). In some embodiments, in the process of removing the portion of the stack structure NSS of the nanosheets N1, N2, and N3 and the portion of each of the sacrificial semiconductor layers 106S, an upper portion of each of the fin-type active regions FA may also be removed. Thereafter, a plurality of source/drain regions 160 may be formed by epitaxially growing a semiconductor material on the exposed opposite side surfaces of the nanosheets N1, N2, and N3 and the exposed surfaces of the fin-type active regions FA.

In some embodiments, some of the source/drain regions 160 may include a different material than the other source/drain regions 160. Some of the source/drain regions 160 and the other source/drain regions 160, which include different materials from each other, may be formed by performing separate epitaxial growth processes. In an implementation, some of the source/drain regions 160 may include Ge. In some embodiments, some of the source/drain regions 160 may have a multi-layer structure of a semiconductor material including Si and a semiconductor material including Ge.

In an implementation, the other source/drain regions 160 may include Si but not Ge. In some embodiments, the other source/drain regions 160 may have a multi-layer structure of a semiconductor material including Si and a semiconductor material such as Si or a compound semiconductor material such as SiC.

After the source/drain regions 160 are formed, an insulating material layer may cover the source/drain regions 160 and fill a portion resulting from the partial removal of the isolation insulating layer CTI. The insulating material layer may include the same material as the isolation insulating layer CTI. The insulating material layer and the residue of the isolation insulating layer CTI may be treated together as the isolation insulating layer CTI.

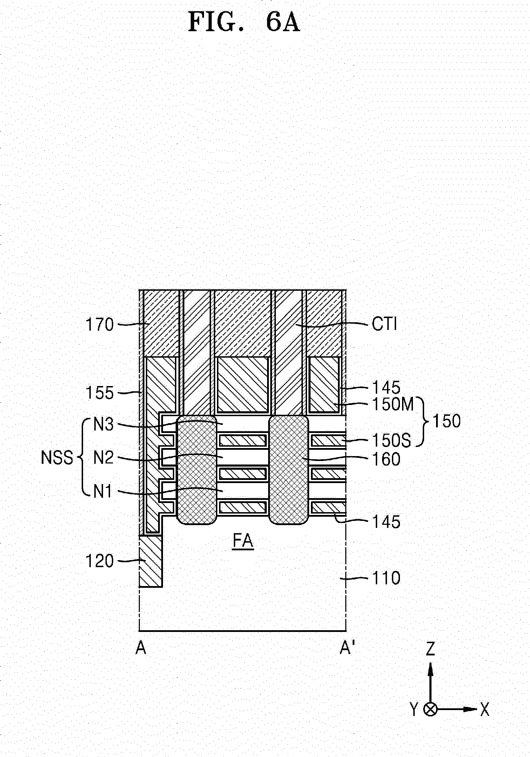

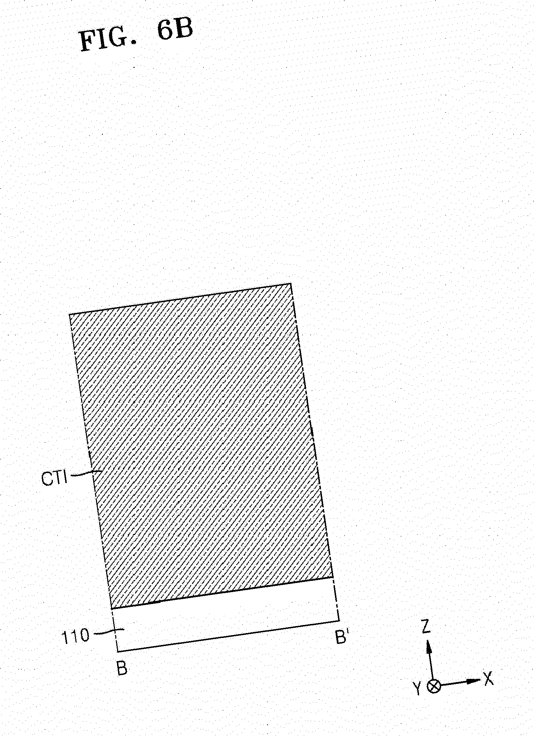

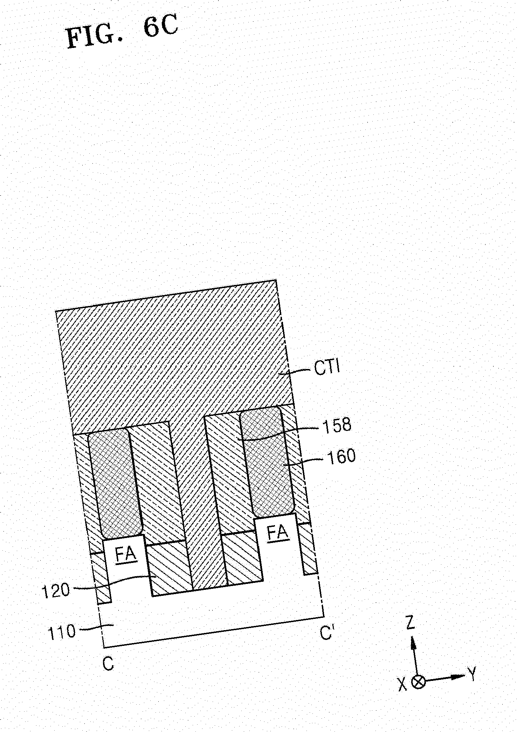

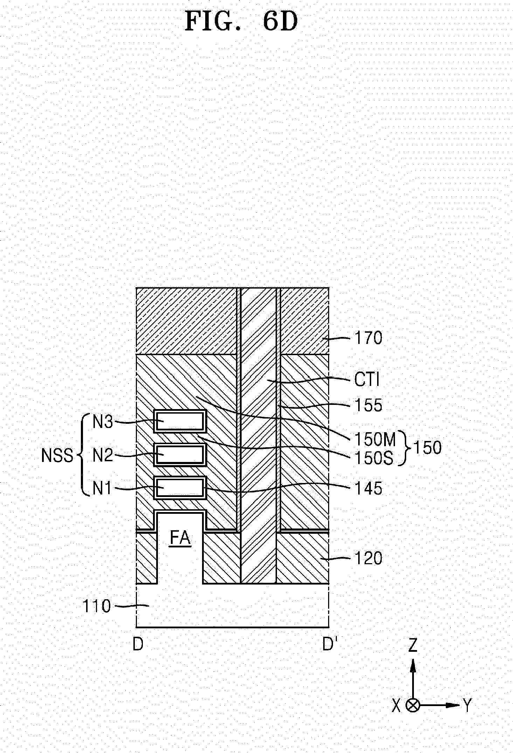

Referring to FIGS. 5A to 5D and FIGS. 6A to 6D, a plurality of dummy gate electrodes D150 and a plurality of dummy insulating films D145 may be removed and the sacrificial semiconductor layers 106S remaining on the fin-type active regions FA may be removed so that a plurality of removal spaces may be formed. Thereafter, a gate insulating film 145 may be formed on surfaces exposed in the removal spaces and a plurality of gate electrodes 150 may be formed on the gate insulating film 145 to fill the removal spaces. The gate electrodes 150 may extend in the second horizontal direction (the Y direction) and may be parallel with each other. The gate electrodes 150 may respectively correspond to the gate electrodes GL in FIG. 1.

The gate insulating film 145 may have a stack structure of an interfacial layer and a high-k dielectric film. In some embodiments, the interfacial layer may include a low-k dielectric layer, e.g., a silicon oxide layer, or a silicon oxynitride layer, which has a permittivity of about 9 or less. In some embodiments, the interfacial layer may be omitted. The high-k dielectric film may include a material having a higher dielectric constant than silicon oxide.

Each of the gate electrodes 150 may include a work function metal layer and a gap-fill metal layer, which is on the work function metal layer and fills a removal space. In some embodiment, each gate electrode 150 may have a structure in which a metal nitride layer, a metal layer, a conductive capping layer, and a gap-fill metal film are sequentially stacked. The metal nitride layer and the metal layer may include Ti, Ta, W, Ru, Nb, Mo, or Hf. The gap-fill metal film may include a W film or an Al film.

The gate electrode 150 may include a main gate portion 150M, which covers the top surface of the nanosheet stack structure NSS including the nanosheets N1, N2, and N3, and a plurality of sub gate portions 150S, which are connected to the main gate portion 150M and formed in the spaces between a fin-type active region FA and the nanosheets N1, N2, and N3. In some embodiments, an insulating spacer may be formed on each of opposite ends of each of the sub gate portions 150S with the gate insulating film 145 between the insulating spacer and each opposite end thereof.

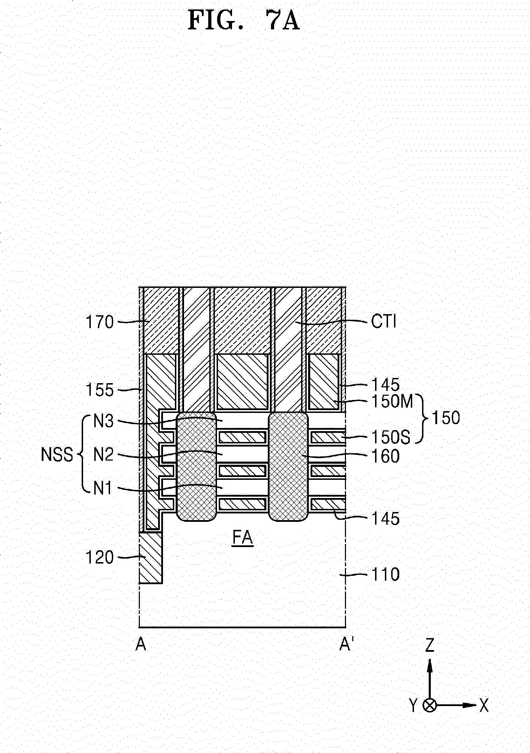

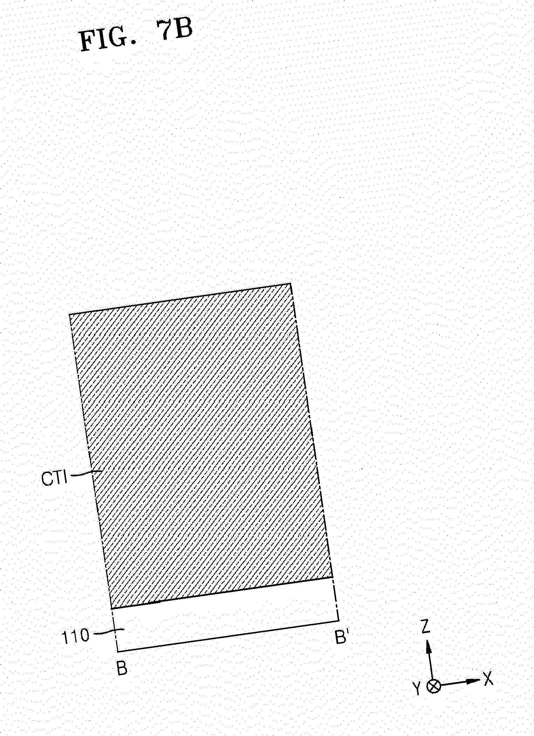

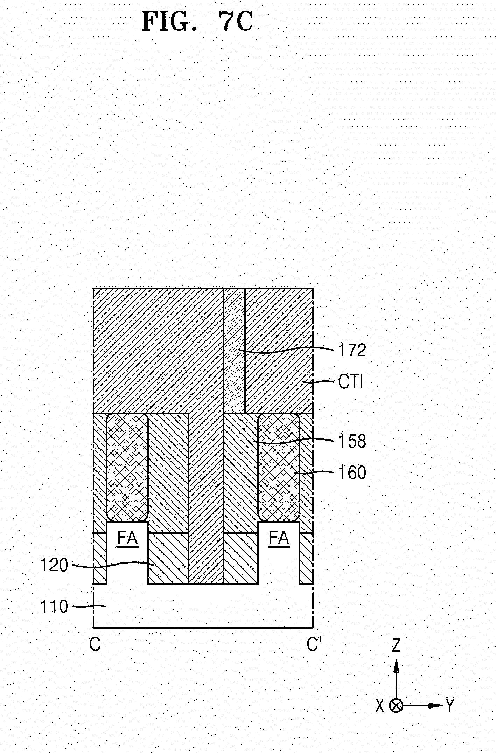

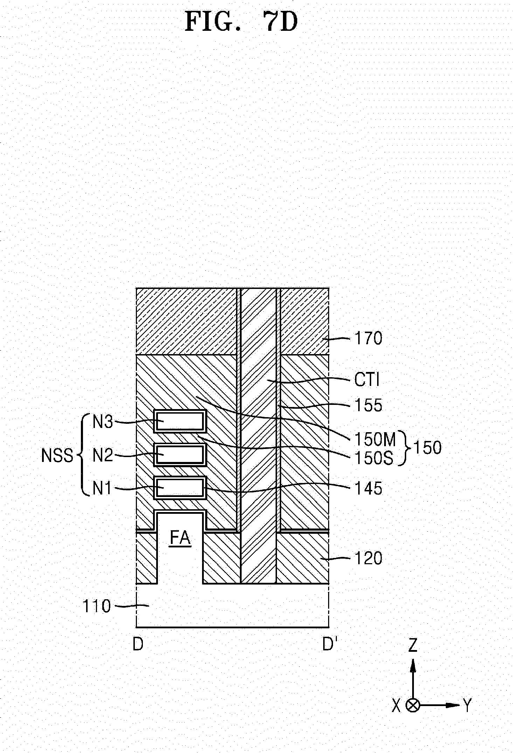

Referring to FIGS. 7A to 7D, a portion of the isolation insulating layer CTI may be removed and filled with an isolation capping layer 172. The isolation capping layer 172 may be between the contact body portion CAB and the contact island CAI in FIG. 2C.

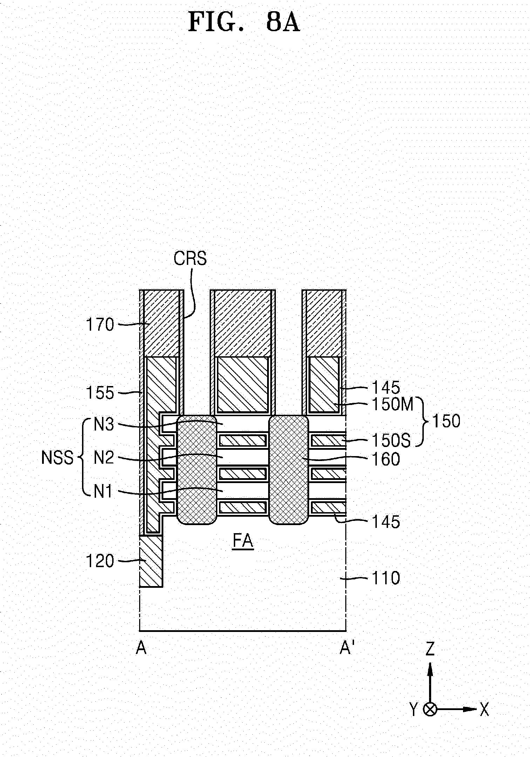

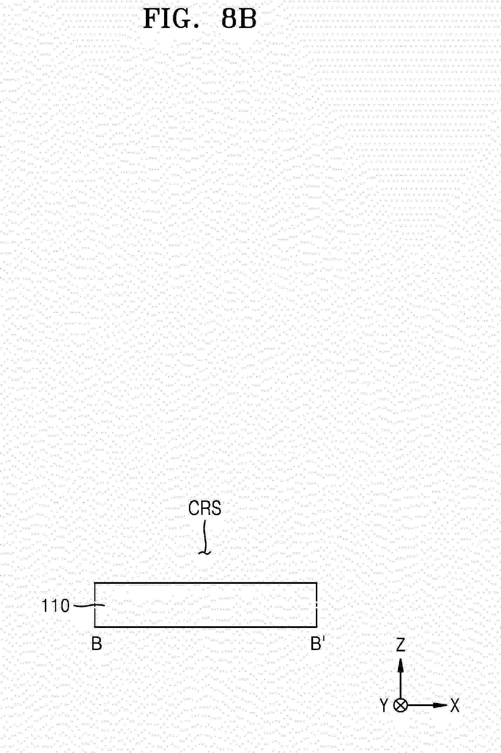

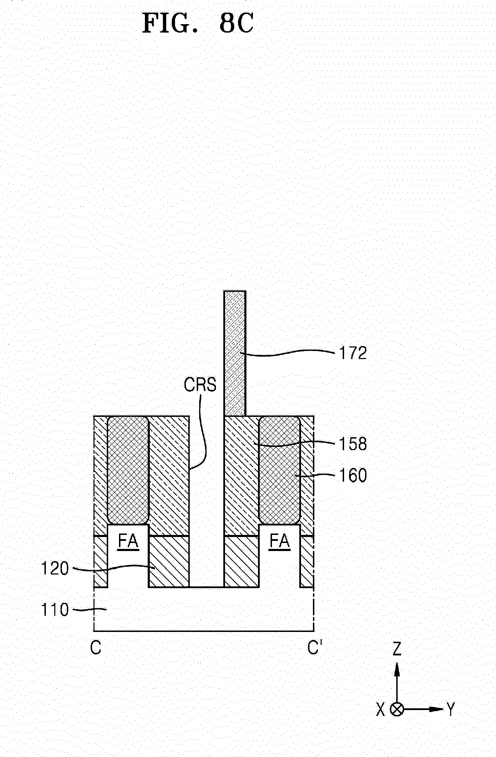

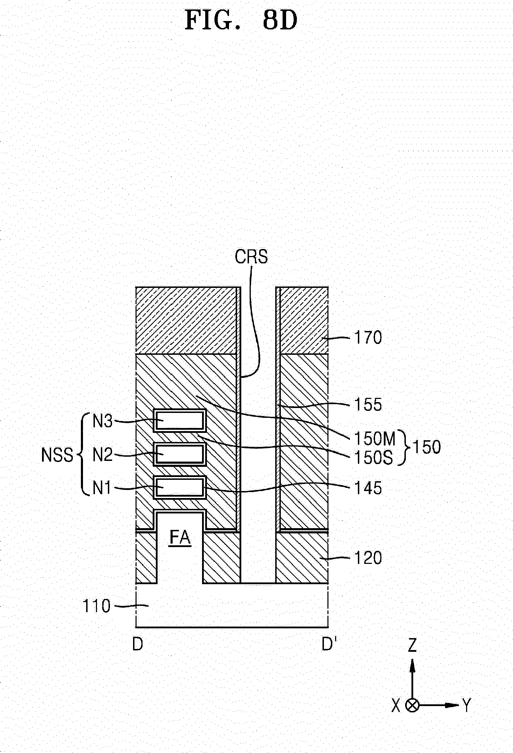

Referring to FIGS. 7A to 7D and FIGS. 8A to 8D, at least a portion of the isolation insulating layer CTI may be removed to form an isolation space CRS. In an implementation, the isolation space CRS may be formed by removing a portion of the isolation insulating layer CTI in a portion corresponding to the plurality of first contacts CA in FIG. 1. In some embodiments, the isolation insulating layer CTI filling the second gate cut region CTS in FIG. 1 may not be removed.

Referring to FIGS. 4A to 4D and FIGS. 5A to 5D, a first contact 210 or CA may fill the isolation space CRS. The first contact 210 or CA may include a contact structure CAS and a contact island CAI. In some embodiments, the first contact 210 or CA may include only the contact structure CAS but not the contact island CAI. The contact structure CAS may include a contact body portion CAB and a contact finger portion CAF. The contact body portion CAB and the contact finger portion CAF may be connected and integrally formed. In some embodiments, the first contact 210 or CA may include a conductive barrier layer and a conductive core layer covering the conductive barrier layer.

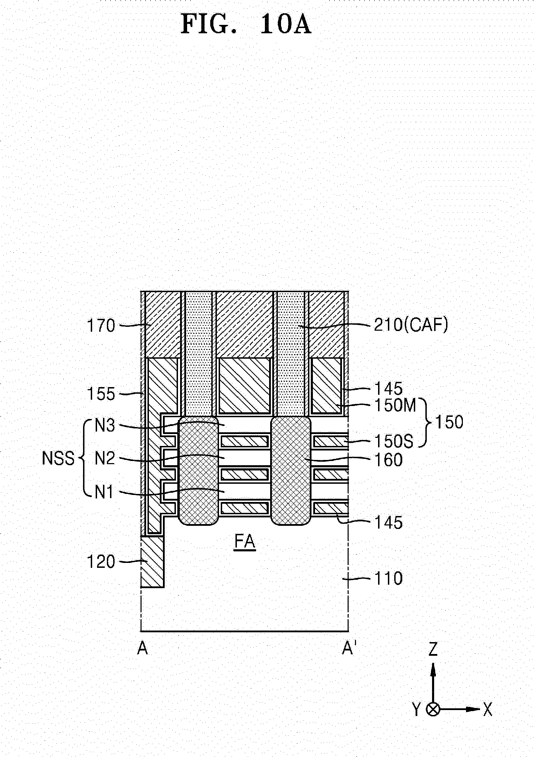

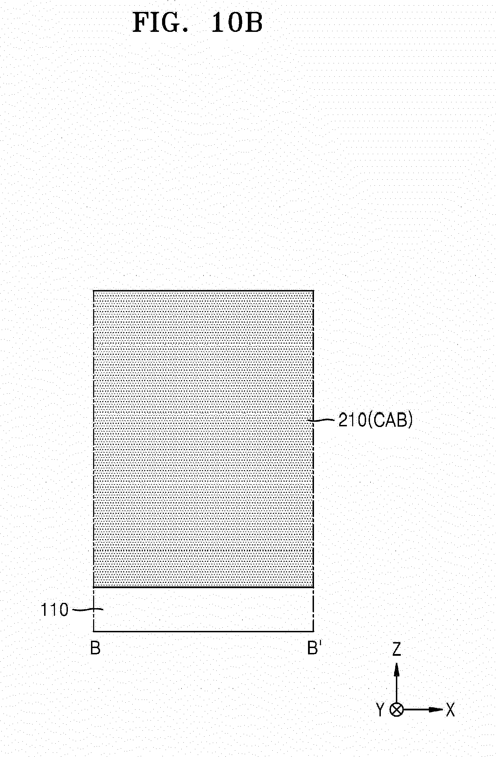

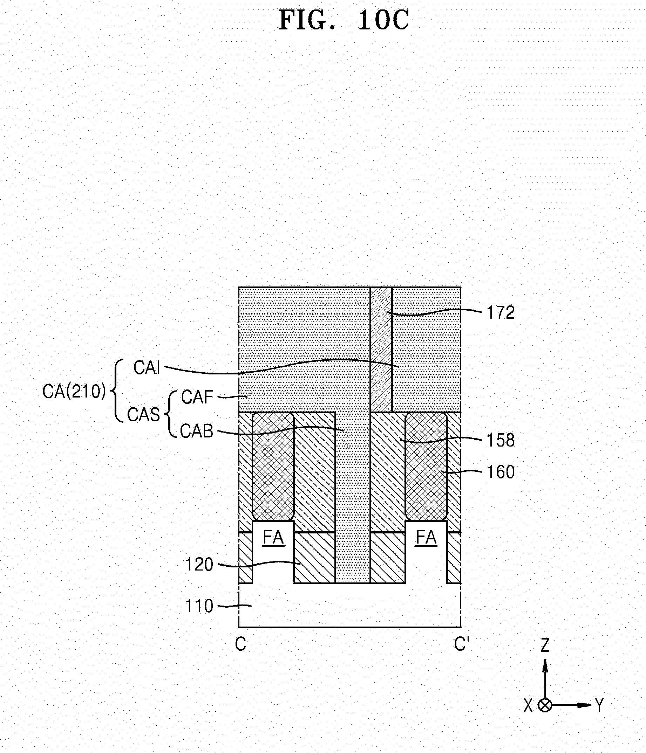

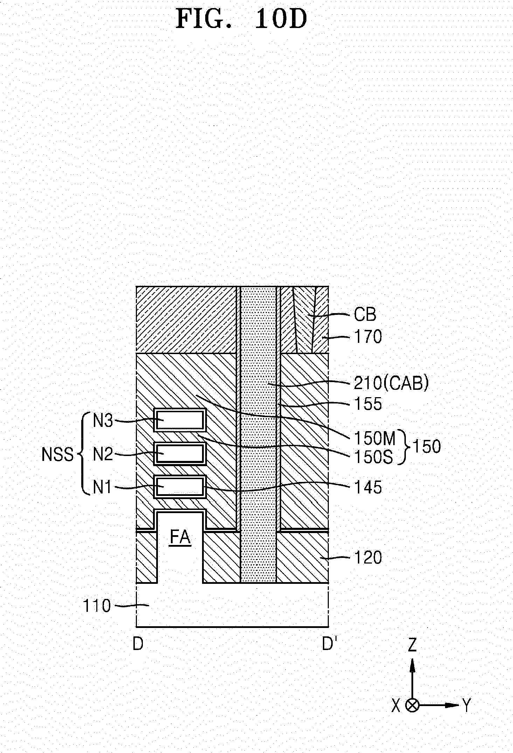

Referring to FIGS. 10A to 10D, a second contact CB may pass through the gate capping layer 170 and to be connected to the gate electrode 150. The second contact CB may have a tapered shape which extends downwards and has a horizontal width decreasing downwards in the vertical direction (the Z direction). The second contact CB may include metal, or conductive metal nitride.

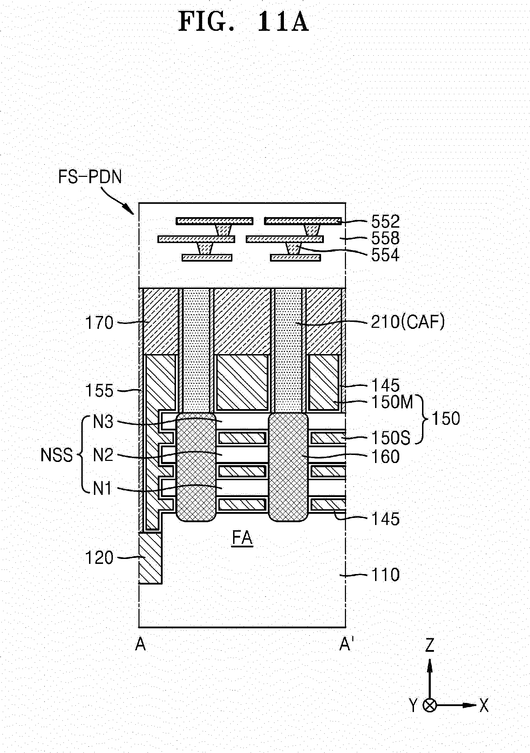

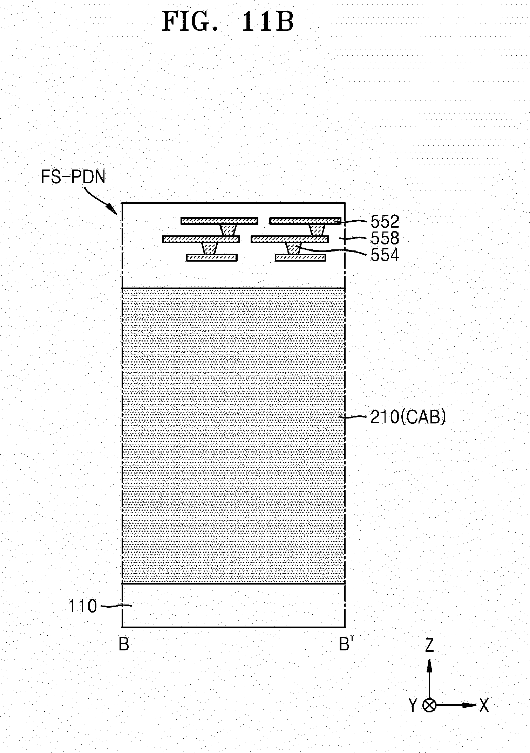

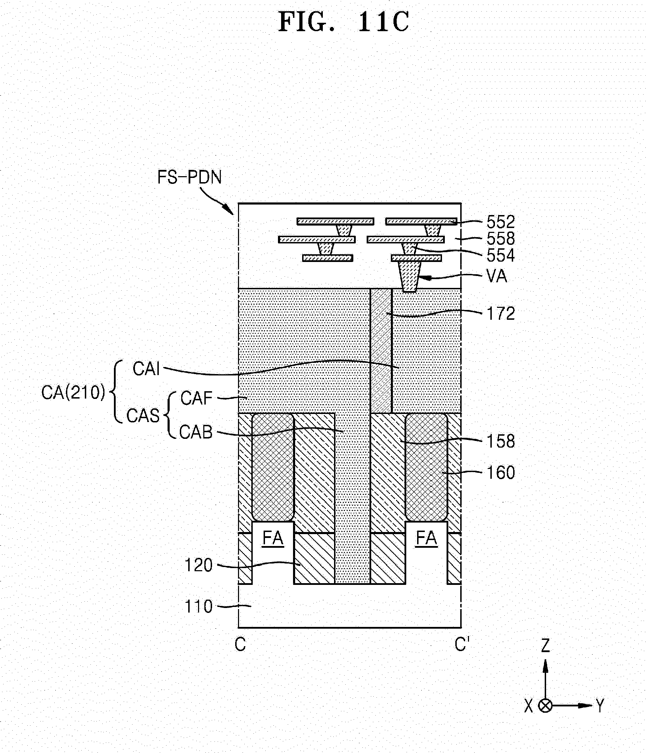

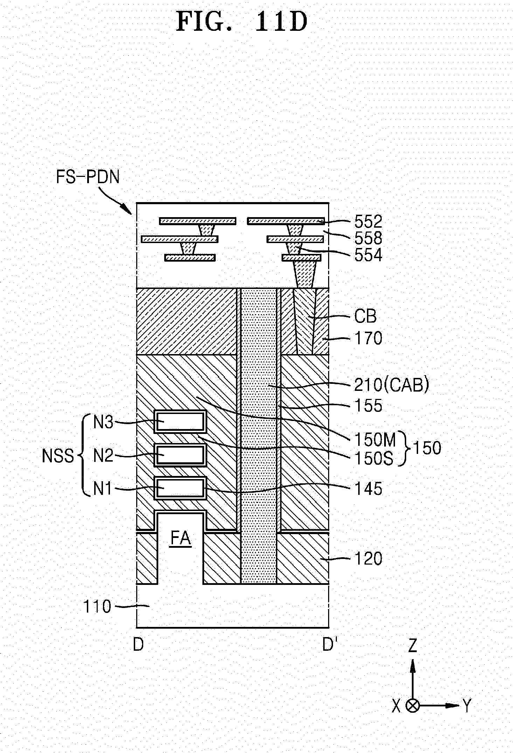

Referring to FIGS. 11A to 11D, an upper wiring structure FS-PDN may be formed on the contact body portion CAB, the contact finger portion CAF, the contact island CAI, the gate capping layer 170, and the isolation capping layer 172.

The upper wiring structure FS-PDN may include a plurality of upper wiring lines 552, a plurality of upper wiring vias 554 each connected to at least one of the upper wiring lines 552, and an upper inter-wiring insulation layer 558 surrounding the upper wiring lines 552 and the upper wiring vias 554. Each of some of the upper wiring vias 554 may electrically connect upper wiring lines 552, which are at different vertical levels, e.g., in different wiring layers, from each other among the plurality of upper wiring lines 552. Each of the upper wiring vias 554 may have a tapered shape which extends downwards and has a horizontal width decreasing downwards in the vertical direction (the Z direction).

Among the upper wiring vias 554, at least one bottommost upper wiring via 554 may be electrically connected to the contact island CAI. At least one bottommost upper wiring via 554 may be a via contact VA electrically connected to the contact island CAI. In an implementation, if a structure including an insulating material is between the upper wiring structure FS-PDN and each of the contact body portion CAB, the contact finger portion CAF, the contact island CAI, the gate capping layer 170, and the isolation capping layer 172, the via contact VA may pass through the insulating material of the structure, and at least one bottommost upper wiring via 554 may be electrically connected to the via contact VA. At least one other bottommost upper wiring via 554 among the plurality of upper wiring vias 554 may be electrically connected to the second contact CB.

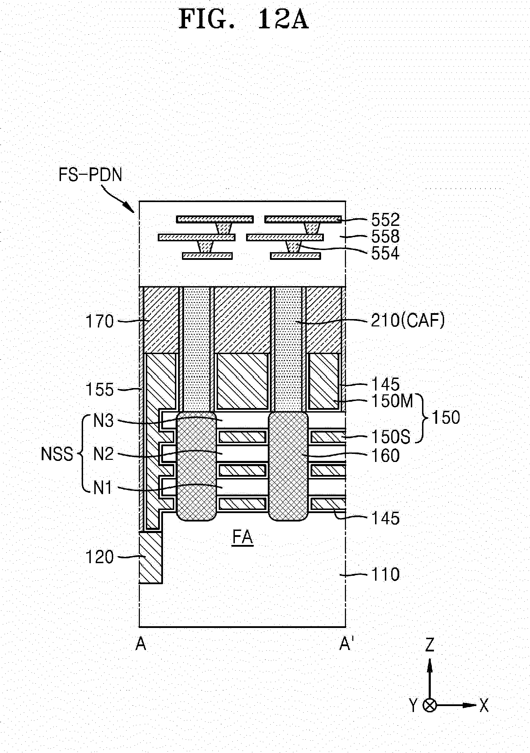

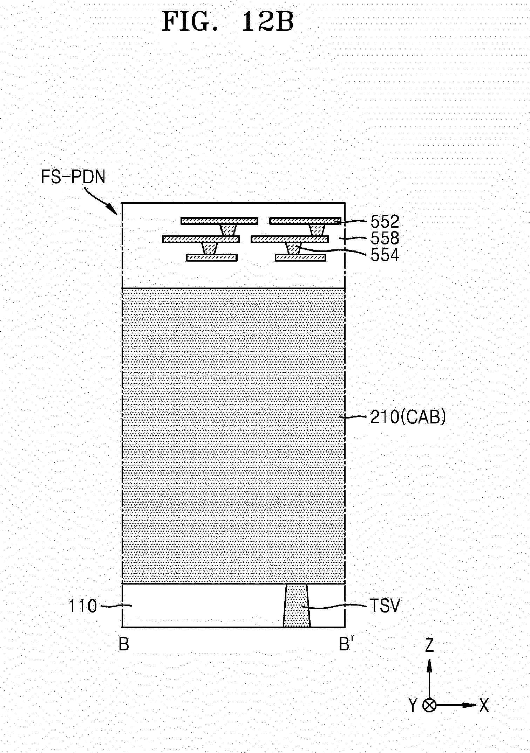

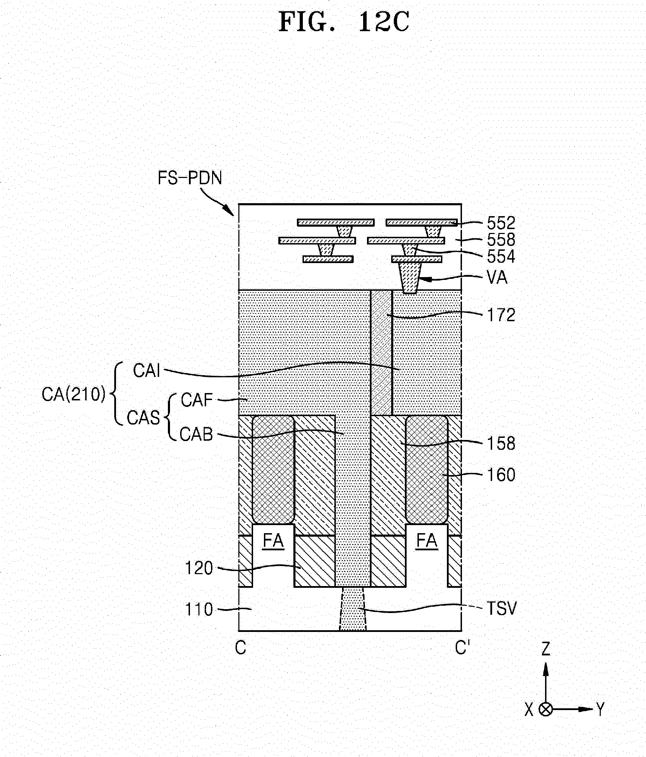

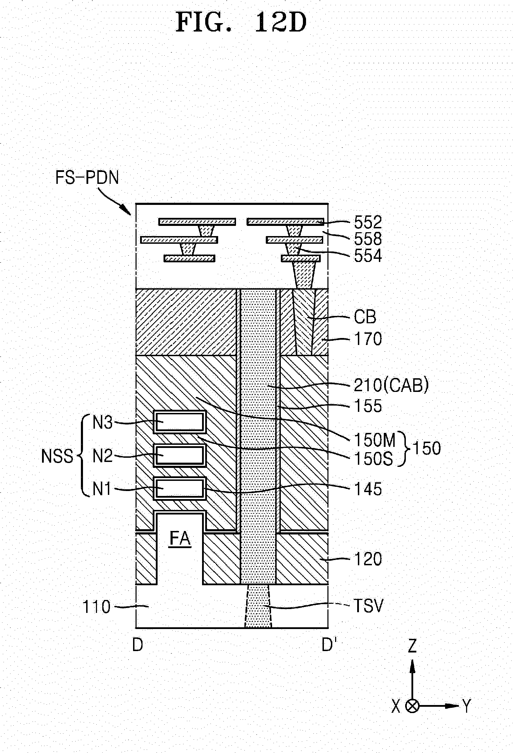

Referring to FIGS. 12A to 12D, a through electrode TSV may extend from the bottom surface of the substrate 110 to the inside of the substrate 110. The through electrode TSV may be in contact with and connected to the contact body portion CAB. In some embodiments, the through electrode TSV may extend from the bottom surface to the top surface of the substrate 110 and be in contact with the contact body portion CAB. In some embodiments if the contact body portion CAB extends to the inside of the substrate 110, the through electrode TSV may extend from the bottom surface of the substrate 110 to the inside of the substrate 110 but not to the top surface of the substrate 110 and to be in contact with and connected to the bottom surface of the contact body portion CAB. The through electrode TSV may have a tapered shape which extends upwards and has a horizontal width decreasing upwards in the vertical direction (the Z direction).

Thereafter, the integrated circuit device 1 may be formed by forming the lower wiring structure BS-PDN in FIGS. 2A to 2D below the substrate 110. The lower wiring structure BS-PDN may include a plurality of lower wiring lines 652, a plurality of lower wiring vias 654 each connected to at least one of the lower wiring lines 652, and a lower inter-wiring insulation layer 658 surrounding the lower wiring lines 652 and the lower wiring vias 654. Each of the lower wiring vias 654 may have a tapered shape which extends upwards and has a horizontal width decreasing upwards in the vertical direction (the Z direction). In some embodiments, if the lower wiring lines 652 are arranged in at least two wiring layers, each of some of the lower wiring vias 654 may electrically connect lower wiring lines 652, which may be at different vertical levels, e.g., in different wiring layers, from each other among the plurality of lower wiring lines 652. The lower wiring vias 654 and the lower wiring lines 652 may be electrically connected to the contact body portion CAB via the through electrode TSV.

Referring to FIGS. 1 to 12D, in the integrated circuit device 1, each of the plurality of contact body portions CAB may be integrally formed with a plurality of contact finger portions CAP corresponding thereto, thereby simplifying manufacturing processes and reducing manufacturing cost. In addition, a separate space for forming the contact body portions CAB electrically connected to the lower wiring structure BS-PDN may not be necessary, and therefore, the integration density of the integrated circuit device 1 may increase and a power delivery network allowing reliable power delivery may be formed in the integrated circuit device 1.

FIGS. 13A and 13B are cross-sectional views showing an integrated circuit device according to example embodiments. FIGS. 13A and 13B are cross-sectional views respectively taken along the lines B-B' and C-C' in FIG. 1.

Referring to FIGS. 13A and 13B, an integrated circuit device 1a may include a first contact 210a or CA instead of the first contact 210 or CA included in the integrated circuit device 1 of FIGS. 2A to 2D. A contact body portion CAB of the first contact 210a or CA may pass through an intergate insulating layer 158 and the substrate 110 and extend to the bottom surface of the substrate 110. The integrated circuit device 1a may not include the through electrode TSV that is included in the integrated circuit device 1 of FIGS. 2A to 2D. The contact body portion CAB of the first contact 210a or CA may be connected to a lower wiring via 654 of the lower wiring structure BS-PDN.

FIGS. 14A and 14B are plan views showing integrated circuit devices according to example embodiments. Referring to FIG. 14A, an integrated circuit device 2 may include a plurality of device regions RX, which extend in the first horizontal direction (the X direction) and are parallel with each other, and a plurality of gate electrodes GL, which extend in the second horizontal direction (the Y direction) that is orthogonal to the first horizontal direction (the X direction) and are parallel with each other. A gate spacer SP may cover the side surfaces of each of the gate electrodes GL. According to a top view, the gate spacer SP may completely surround the gate electrode GL. The plurality of gate electrodes GL and a plurality of gate spacers SP respectively corresponding to the gate electrodes GL may form a plurality of gate structures GS.

A plurality of first gate cut regions CTL may extend in the first horizontal direction (the X direction) and may be parallel with each other. Each of the first gate cut regions CTL may be between a pair of device regions RX adjacent to each other in the second horizontal direction (the Y direction).

The first gate cut regions CTL may extend in the first horizontal direction (the X direction) and cut the gate electrodes GL, which extend in the second horizontal direction (the Y direction). One of the first gate cut regions CTL may extend in the first horizontal direction (the X direction) and cut each of the gate electrodes GL, which extend in the second horizontal direction (the Y direction), into two parts. Gate electrodes GL arranged in line in the second horizontal direction (the Y direction) among the plurality of gate electrodes GL may be separated from one another by a plurality of first gate cut regions CTL.

At least one second gate cut region CTS may extend in the first horizontal direction (the X direction). The second gate cut region CTS may extend in the first horizontal direction (the X direction) and thus cut some of the gate electrodes GL extending in the second horizontal direction (the Y direction). One second gate cut region CTS may extend in the first horizontal direction (the X direction) and cut each of some of the gate electrodes GL, which extends in the second horizontal direction (the Y direction), into two parts. Gate electrodes GL arranged in line in the second horizontal direction (the Y direction) among the plurality of gate electrodes GL may be separated from one another by the first gate cut regions CTL and the second gate cut region CTS. The second gate cut region CTS may be separated from the first gate cut regions CTL.

A contact body portion CAB and an isolation insulating layer CTI may be in each of the first gate cut regions CTL. In some embodiments, the contact body portion CAB and the isolation insulating layer CTI may completely fill each of the first gate cut regions CTL. The gate spacer SP and the isolation insulating layer CTI may be between each of the gate electrodes GL and the contact body portion CAB. A plurality of contact body portions CAB filling the first gate cut regions CTL may extend in the first horizontal direction (the X direction). The isolation insulating layer CTI may cover the opposite side surfaces in the second horizontal direction (the Y direction) of each of the contact body portions CAB. A contact finger portion CAF may extend in the second horizontal direction (the Y direction) from a contact body portion CAB to be above a portion of a device region RX. In an implementation, a plurality of contact finger portions CAF may extend in the second horizontal direction (the Y direction) from one of the opposite sides in the second horizontal direction (the Y direction) of the contact body portion CAB or may extend in opposite directions of the second horizontal direction (the Y direction and the -Y direction) from both the opposite sides in opposite directions of the second horizontal direction (the Y direction and the -Y direction) of the contact body portion CAB. The contact body portion CAB and the contact finger portion CAF may integrally form a contact structure CAS.

An isolation insulating layer CTI may be in the second gate cut region CTS. The isolation insulating layer CTI may completely fill the second gate cut region CTS. The isolation insulating layer CTI in each of the first gate cut regions CTL may be referred to as a first isolation insulating layer and the isolation insulating layer CTI filling the second gate cut region CTS may be referred to as a second isolation insulating layer.

The plurality of source/drain regions 160 (in FIGS. 2A and 2C) may be respectively on a plurality of device regions RX between a pair of gate electrodes GL adjacent to each other in the first horizontal direction (the X direction). The contact finger portion CAF or a contact island CAI may be connected to each of the source/drain regions 160. The contact finger portion CAF may be on each of some of the source/drain regions 160 and the contact island CAI may be on each of the other source/drain regions 160. A plurality of contact islands CAI may be separated from each other. The contact islands CAI may be separated from the contact structure CAS. The contact structure CAS and the contact islands CAI may be collectively referred to as a first contact CA.

A via contact VA may be on a contact island CAI but not on the contact structure CAS, which may include the contact body portion CAB and the contact finger portion CAF. Some source/drain regions 160 connected to the contact finger portion CAF may be electrically connected to the contact body portion CAB and the other source/drain regions 160 connected to the contact island CAI may be electrically connected to the via contact VA. A second contact CB may be on a gate electrode GL.

Referring to FIG. 14B, an integrated circuit device 2a may include a plurality of device regions RX, which extend in the first horizontal direction (the X direction) and are parallel with each other, and a plurality of gate electrodes GL, which extend in the second horizontal direction (the Y direction) that is orthogonal to the first horizontal direction (the X direction) and are parallel with each other. A gate spacer SP may cover the side surfaces of each of the gate electrodes GL. According to a top view, the gate spacer SP may completely surround the gate electrode GL. The plurality of gate electrodes GL and a plurality of gate spacers SP respectively corresponding to the gate electrodes GL may form a plurality of gate structures GS.

A plurality of first gate cut regions CTL may extend in the first horizontal direction (the X direction) and may be parallel with each other. Each of the first gate cut regions CTL may be between a pair of device regions RX adjacent to each other in the second horizontal direction (the Y direction).

The first gate cut regions CTL may extend in the first horizontal direction (the X direction) and cut the gate electrodes GL, which extend in the second horizontal direction (the Y direction). One of the first gate cut regions CTL may extend in the first horizontal direction (the X direction) and cut each of the gate electrodes GL, which extend in the second horizontal direction (the Y direction), into two parts. Gate electrodes GL arranged in line in the second horizontal direction (the Y direction) among the plurality of gate electrodes GL may be separated from one another by a plurality of first gate cut regions CTL.

At least one second gate cut region CTS may extend in the first horizontal direction (the X direction). The second gate cut region CTS may extend in the first horizontal direction (the X direction) and thus cut some of the gate electrodes GL extending in the second horizontal direction (the Y direction). One second gate cut region CTS may extend in the first horizontal direction (the X direction) and cut each of some of the gate electrodes GL, which extends in the second horizontal direction (the Y direction), into two parts. Gate electrodes GL arranged in line in the second horizontal direction (the Y direction) among the plurality of gate electrodes GL may be separated from one another by the first gate cut regions CTL and the second gate cut region CTS. The second gate cut region CTS may be separated from the first gate cut regions CTL.

A contact body portion CAB may be in each of the first gate cut regions CTL. In some embodiments, the contact body portion CAB may completely fill each of the first gate cut regions CTL. A plurality of contact body portions CAB respectively filling the first gate cut regions CTL may extend in the first horizontal direction (the X direction). A gate spacer SP may be between a gate electrode GL and a contact body portion CAB. The isolation insulating layer CTI may partially cover the opposite side surfaces in the second horizontal direction (the Y direction) of each of the plurality of contact body portions CAB. The isolation insulating layer CTI may be between a pair of adj acent gate structures GS and cover a portion of each of the opposite side surfaces in the second horizontal direction (the Y direction) of each of the contact body portions CAB. A contact finger portion CAF may extend in the second horizontal direction (the Y direction) from a contact body portion CAB to be above a portion of a device region RX. In an implementation, a plurality of contact finger portions CAF may extend in the second horizontal direction (the Y direction) from one of the opposite sides in the second horizontal direction (the Y direction) of the contact body portion CAB or may extend in opposite directions of the second horizontal direction (the Y direction and the -Y direction) from both the opposite sides in opposite directions of the second horizontal direction (the Y direction and the -Y direction) of the contact body portion CAB. The contact body portion CAB and the contact finger portion CAF may integrally form a contact structure CAS.

An isolation insulating layer CTI may be in the second gate cut region CTS. The isolation insulating layer CTI may completely fill the second gate cut region CTS. The isolation insulating layer CTI covering a portion of each of the opposite side surfaces in the second horizontal direction (the Y direction) of the contact body portion CAB may be referred to as a first isolation insulating layer, and the isolation insulating layer CTI filling the second gate cut region CTS may be referred to as a second isolation insulating layer.

The plurality of source/drain regions 160 (in FIGS. 2A and 2C) may be respectively on a plurality of device regions RX between a pair of gate electrodes GL adjacent to each other in the first horizontal direction (the X direction). The contact finger portion CAF or a contact island CAI may be connected to each of the source/drain regions 160. The contact finger portion CAF may be on each of some of the source/drain regions 160, and the contact island CAI may be on each of the other source/drain regions 160. A plurality of contact islands CAI may be separated from each other. The contact islands CAI may be separated from the contact structure CAS. The contact structure CAS and the contact islands CAI may be collectively referred to as a first contact CA.

A via contact VA may be on a contact island CAI but not on the contact structure CAS, which may include the contact body portion CAB and the contact finger portion CAF. Some source/drain regions 160 connected to the contact finger portion CAF may be electrically connected to the contact body portion CAB and the other source/drain regions 160 connected to the contact island CAI may be electrically connected to the via contact VA. A second contact CB may be on a gate electrode GL.

By way of summation and review, integrated circuit devices having therein a power delivery network capable of reliably transmitting power to highly integrated elements thereof are disclosed.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. An integrated circuit device, comprising:
a substrate having a plurality of device regions extending in a first horizontal direction;
a plurality of gate electrodes on the plurality of device regions and extending in a second horizontal direction that is orthogonal to the first horizontal direction;
a plurality of source/drain regions each located between a pair of gate electrodes adjacent to each other in the first horizontal direction among the plurality of gate electrodes, the plurality of source/drain regions being on portions of the plurality of device regions;
a plurality of first gate cut regions cutting the plurality of gate electrodes and extending in the first horizontal direction; and
a plurality of contact structures including a plurality of contact body portions and a plurality of contact finger portions, the plurality of contact body portions filling the plurality of first gate cut regions and extending in the first horizontal direction, and the plurality of contact finger portions extending in the second horizontal direction from the plurality of contact body portions and being connected to at least some of the plurality of source/drain regions.

2. The integrated circuit device as claimed in claim 1, further comprising a plurality of gate spacers covering side surfaces of the plurality of gate electrodes, the plurality of gate electrodes being separated from the plurality of contact body portions by the plurality of gate spacers.

3. The integrated circuit device as claimed in claim 2, wherein, according to a top view, each of the plurality of gate spacers completely surrounds its corresponding one among the plurality of gate electrodes.

4. The integrated circuit device as claimed in any one of claims 1 to 3, wherein the plurality of contact body portions extend downward in a vertical direction from a higher vertical level than a top surface of each of the plurality of source/drain regions.

5. The integrated circuit device as claimed in claim 4, wherein a bottom surface of the plurality of contact body portions is at a lower vertical level than a bottom surface of the plurality of contact finger portions.

6. The integrated circuit device as claimed in claim 4 or 5, wherein the plurality of contact body portions extend into the substrate.

7. The integrated circuit device as claimed in any one of claims 4 to 6, wherein the plurality of contact body portions pass through the substrate and extend to a bottom surface of the substrate.

8. The integrated circuit device as claimed in any one of claims 4 to 7, further comprising a lower wiring structure below the substrate, the lower wiring structure including a plurality of lower wiring lines, a plurality of lower wiring vias connected to at least one of the plurality of lower wiring lines, and a lower inter-wiring insulation layer surrounding the plurality of lower wiring lines and the plurality of lower wiring vias, the at least some of the plurality of source/drain regions being electrically connected to at least some of the plurality of lower wiring lines and at least some of the plurality of lower wiring vias through the plurality of contact structures.

9. The integrated circuit device claim 1, comprising a plurality of gate structures including the plurality of gate electrodes and a plurality of gate spacers, the plurality of gate spacers covering side surfaces of the plurality of gate electrodes,
each of the plurality of source/drain regions being located between a pair of gate structures adjacent to each other in the first horizontal direction among the plurality of gate structures and
the plurality of contact structures being separated from the plurality of gate electrodes by the plurality of gate spacers.

10. The integrated circuit device as claimed in claim 9, wherein some of the plurality of contact finger portions extend from one of opposite side surfaces in the second horizontal direction of the plurality of contact body portions to top surfaces of some of the plurality of source/drain regions, and the other contact finger portions extend from the other one of the opposite side surfaces in the second horizontal direction of the plurality of contact body portions to top surfaces of the other source/drain regions.

11. The integrated circuit device as claimed in claim 9 or 10, wherein the plurality of gate spacers cover opposite side surfaces in the first horizontal direction of the plurality of gate electrodes and opposite side surfaces in the second horizontal direction of the plurality of gate electrodes.

12. The integrated circuit device as claimed in any one of claims 9 to 11, wherein a top surface of the plurality of contact body portions is at a same vertical level as a top surface of the plurality of contact finger portions, and a bottom surface of the plurality of contact body portions is at a lower vertical level than a bottom surface of the plurality of contact finger portions.

13. The integrated circuit device as claimed in any one of claims 9 to 12, further comprising:
a lower wiring structure below the substrate; and
an upper wiring structure on the plurality of gate electrodes,
wherein the plurality of contact structures are electrically connected to the lower wiring structure and the plurality of gate electrodes are electrically connected to the upper wiring structure.

14. The integrated circuit device as claimed in any one of claims 9 to 13, further comprising:
at least one second gate cut region separated from the plurality of first gate cut regions, the at least one second gate cut region cutting some of the plurality of gate electrodes and extending in the first horizontal direction; and
an isolation insulating layer filling the at least one second gate cut region.

15. The integrated circuit device as claimed in claim 9, wherein:
the plurality of gate structures includes a gate capping layer on the plurality of gate electrodes, and a plurality of gate insulating films, the plurality of gate spacers surrounding the side surfaces of the plurality of gate electrodes according to a top view, and the plurality of gate insulating films being between the plurality of gate electrodes and the plurality of gate spacers,
the plurality of first gate cut regions each extend in the first horizontal direction between a pair of device regions adjacent to each other in the second horizontal direction among the plurality of device regions, and
the plurality of contact structures extend into the substrate in a vertical direction.
